(19) Europäisches Patentamt
European Patent Office
Office européen des brevets

(11) **EP 4 549 967 B1**

(12) **EUROPEAN PATENT SPECIFICATION**

(45) Date of publication and mention
of the grant of the patent:
**29.04.2026 Bulletin 2026/18**

(21) Application number: **24210299.4**

(22) Date of filing: **31.10.2024**

(51) International Patent Classification (IPC):
*G01R 31/367* (2019.01)     *G01R 31/382* (2019.01)
*G01R 31/392* (2019.01)     *G01R 31/396* (2019.01)

(52) Cooperative Patent Classification (CPC):
**G01R 31/367; G01R 31/382; G01R 31/392;
G01R 31/396; G06N 3/02; G06N 3/044;
G06N 3/045; G06N 3/048; G06N 3/08; G06N 3/084;
G06N 3/088; G06N 20/00; G06N 20/10**

(54) **SYSTEM AND METHOD FOR DETECTING THE DEGRADATION OF BATTERY ENERGY STORAGE SYSTEMS AND THE WARRANTY TRACKING THEREOF**

SYSTEM UND VERFAHREN ZUR ERKENNUNG DER VERSCHLECHTERUNG VON BATTERIEENERGIESPEICHERSYSTEMEN UND GARANTIEVERFOLGUNG DAFÜR

SYSTÈME ET PROCÉDÉ DE DÉTECTION DE LA DÉGRADATION DE SYSTÈMES DE STOCKAGE D'ÉNERGIE DE BATTERIE ET DE SUIVI DE GARANTIE ASSOCIÉ

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **06.11.2023 US 202318387130**

(43) Date of publication of application:
**07.05.2025 Bulletin 2025/19**

(73) Proprietor: **Honeywell International Inc.**
**Charlotte, NC 28202 (US)**

(72) Inventors:
• **MANIKFAN, Sameer D.**
**Charlotte, 28202 (US)**
• **TRENCHARD, Andrew J.**
**Charlotte, 28202 (US)**
• **KN, Dinesh Kumar**
**Charlotte, 28202 (US)**

(74) Representative: **Haseltine Lake Kempner LLP**
**Cheapside House**
**138 Cheapside**
**London EC2V 6BJ (GB)**

(56) References cited:
**WO-A1-2022/147080     CN-A- 113 064 093
CN-A- 115 291 113**

**Description**

TECHNICAL FIELD

This disclosure is generally directed to battery energy storage systems. More specifically, it relates to a system and method for detecting the degradation of battery energy storage systems and the tracking of the battery energy storage systems for purposes of replacement under a warranty.

BACKGROUND

Currently, most electric power is generated by large, centralized power plants, such as nuclear powerplants, hydroelectric plants, and fossil fuel powered plants. These large facilities frequently generate power using non-renewable sources of energy, such as coal or gas. Such power plants commonly have good economies of scale, however due to various economic and operational reasons may not provide all of the power required to service the loads of the electrical grid services by the centralized power plant. Battery energy storage systems having stored power may be connected at a power plant, substation, transmission line or at a customer site to selectively use stored battery energy to supplement or provide all the power required by the grid, thereby preventing service interruptions. Battery energy storage systems employ chemical energy storage batteries that chemically store energy such as for example a lithium iron (LiON) batteries, lead acid batteries (Pb), or sodium-sulfur (NAS) batteries.

Degradation of battery energy storage systems, specifically batteries based on LiON cells is an irreversible process that is dependent on the current and temperature a battery cell was subjected to when a voltage or a potential difference was applied across its terminals. The battery cell voltage is dependent on the state of charge in the cell. LiON battery chemistry becomes unstable when the voltage across the battery terminals goes below a minimum threshold. The cell impedance will also increase in such an occurrence, and a medium to high charging current can cause temperature to rise that aggravates the degradation of the battery cell. Similar situations exist at the high voltage, when overcharging results in a faster degradation of the battery cell.

Protecting the integrity of the battery data with regard to battery degradation is also a need for suppliers of battery energy storage systems, as it is prone to data tamper, especially by users who may subject a battery system to abusive cycles and still claim warranty costs or replacements. A battery warranty tracking system is intended to make battery data reflecting the health of the battery energy storage system tamper proof so that any tampered data becomes unusable for warranty claim's purpose.

Prior art CN115291113A discloses an arrangement for estimating battery SOH/SOC, using two different trained models, one for SOH, and another for SOC. The SOH prediction data can be used to calibrate the SOC estimate.

The present disclosure describes a system and method for detecting the degradation of battery energy storage systems by detecting the state of charge of a battery management system to enable auto-calibration of the battery management system and the tracking of battery degradation for purposes of replacement of the battery energy storage system under a warranty.

SUMMARY

This disclosure relates to a system and method for detecting the degradation of battery energy storage systems by detecting the state of charge of a battery management system and the tracking of battery degradation for purposes of replacement under a warranty. Aspects of the present invention are defined in the claims. According to a first aspect there is provided a system in accordance with claim 1. According to a second aspect there is provided a method in accordance with claim 10. Advantageously optional features are defined in the dependent claims.

In a first embodiment a system for detecting the degradation of a storage battery for at least one battery energy storage system (BESS) container is disclosed. The system includes a battery management system (BMS) coupled to the storage battery configured to collect battery operational data from the storage battery. A battery data repository coupled to the BMS receives and stores the battery operational data. A learning agent coupled to the battery data repository uses the stored battery operational data to estimate a prognostic degradation of the storage battery and train a degradation estimation model, wherein a state of charge (SOC) estimation agent receives and uses the trained degradation estimation model to generate a real-time estimate of the SOC of the storage battery for scheduling charge/discharge cycles for the BESS container.

The system further includes review and validation of battery parameters by an expert user comprising a battery digital twin configured to receive operational data from the BESS container including charge/discharge current and ambient temperature to generate a simulated voltage response and a simulated rise in temperature. A mean square error model receives an actual voltage response and an actual rise in temperature from the BMS and the simulated voltage response and simulated temperature from the battery digital twin and is configured to output a mean square error output. A hybrid parameter identification model receives the mean square error output to generate estimates of changes in battery parameters based on charge/discharge current and ambient temperature input to the hybrid parameter identification model, wherein the changes in the battery parameters are uploaded to an expert user for review and validation of the changed battery parameters.

A warranty tracking system includes storing the battery operational data as a plain text file in the BESS container wherein a private key generator coupled to an RNN battery model is configured to send simulated battery data and a unique identifier to the private key generator that produces a private encryption key that is coupled to an encryption agent. The plain text file is encrypted into an encrypted text file by the encryption agent using the private encryption key. A data storage platform remotely located from the BESS container has a data repository coupled to the encryption agent and is arranged to receive and store the encrypted text file. A key generator located on the data storage platform coupled to the RNN battery model generates a public encryption key using the simulated battery data from the RNN battery model. Upon request from a user, a decryption agent coupled to the data repository receives the encrypted text file and public encryption key and decrypts the encrypted text file to a plain text file.

In a second embodiment a method for detecting the degradation of a storage battery of at least one battery energy storage system (BESS) container is disclosed. The method comprises collecting battery operational data from a battery management system (BMS) coupled to the storage battery and storing the battery operational data in a data repository. A degradation estimation model is trained using the stored battery operational data to estimate a prognostic degradation of the storage battery. The method further comprises generating using the trained degradation estimation model a real-time estimate of the state of charge (SOC) of the storage battery for scheduling charge/discharge cycles for the storage battery.

The method further includes review and validation of battery parameters by an expert user comprising receiving operational data from BESS container including charge/discharge current and ambient temperature by a battery digital twin. Generating by the battery digital twin a simulated voltage response and a simulated rise in temperature using the operational data. Generating a means square error output using an actual voltage response and an actual rise in temperature from the BMS and the simulated voltage response and the simulated temperature from the digital twin to generate estimates of changes in battery parameters based on charge/discharge current and ambient temperature using the mean square error output, wherein the changes in the battery parameters is presented to an expert user for review and validation of the changed battery parameters.

A warranty tracking method includes storing the battery operational data as a plain text file in the BESS container. A private key generator coupled to an RNN battery model, is configured to send simulated battery data and a unique identifier to the private key generator to produce a private encryption key, wherein the private encryption key is used by an encryption agent to encrypt the plain text file. The encrypted text file is stored in a data repository of a data storage platform remotely located from the BESS container. A key generator located on the data storage platform is coupled to the RNN battery model and is configured to generate a public encryption key using the simulated battery data from the RNN battery model. The method further includes sending upon a request of a user the encrypted text file and public encryption key to a decryption agent that decrypts the encrypted text file to a plain text file.

In a third embodiment a computer program product is disclosed comprising a non-transitory data storage medium that includes program instructions executable by a processor to enable the processor to execute a method for the detection of the degradation of a storage battery of at least one battery energy storage system, the method comprising collecting battery operational data from the storage battery and storing the battery operational data in a data repository. A degradation estimation model is trained using the stored battery operational data to estimate a prognostic degradation of the storage battery and generating using the trained degradation estimation model a real-time estimate of the state of charge of the storage battery.

Other technical features may be readily apparent to one skilled in the art from the following figures, descriptions, and claims.

BRIEF DESCRIPTION OF THE DRAWINGS

For a more complete understanding of this disclosure, reference is now made to the following description, taken in conjunction with the accompanying drawings, in which:

FIG. 1 is a diagram schematically illustrating a multi-level control system used in controlling a battery energy storage system;

FIG. 2 is a diagram schematically illustrating a battery energy storage system container;

FIG. 3 is diagram schematically illustrating the energy control system used in controlling a battery energy storage system;

FIG. 4 is diagram schematically illustrating an embodiment of an exemplary system for detecting the degradation of a battery energy storage system according to the present disclosure;

FIG. 5 is diagram schematically illustrating an exemplary battery rack digital twin for detecting the degradation of battery energy storage system according to the present disclosure;

FIG. 6 is diagram schematically illustrating an exemplary battery module digital twin for detecting the degradation of a battery energy storage system according to the present disclosure;

FIG. 7 is diagram schematically illustrating an embodiment of an exemplary system for detecting the degradation of a battery energy storage system that uses an expert user to review and validate battery model parameters according to the present disclosure;

FIG. 8 is diagram schematically illustrating an embodiment of an exemplary system for detecting the degradation of a battery energy storage system that includes a warranty tracking system used to protect the integrity of the battery data of the battery storage system according to the present disclosure; and

FIG. 9 is diagram schematically illustrating the data storage platform of the according to the present disclosure.

## DETAILED DESCRIPTION

The figures discussed below, and the various embodiments used to describe the principles of the present invention in this patent document are by way of illustration only and should not be construed in any way to limit the scope of the invention. Those skilled in the art will understand that the principles of the invention may be implemented in any type of suitably arranged device or system.

The degradation of the storage battery of a battery energy storage system (BESS) is not linear over the entire range of voltage, current and temperature for the battery cells contained in the BESS. Approximations that assume linearity in the estimation of state of charge (SOC) based on measured battery cell voltage and current at different temperatures can cause errors in the estimation of SOC of the battery cells of the BESS.

A battery cells SOC is typically calibrated when the BESS is installed and commissioned and before it is used. Calibration is also required periodically, for example, every three to six months. The calibration process requires the BESS to be taken out of service and cycled from a low SOC limit to a high SOC limit, multiple times. This is time consuming, and renders the BESS unavailable, when the calibrations are performed. The calibration exercise also uses some of the remaining useful life of the BESS batteries, and therefore reduces the life of the BESS storage battery. An accurate estimation of SOC between the calibrations is useful to avoid degradations that are due to inaccurate estimation of SOC. When a reduction in a BESS energy capacity is not estimated accurately and an incorrect state of charge is computed, shallow battery cycles become prone to errors in estimation when either higher or lower SOC limits are reached. For example, if the battery cells of the BESS are regularly cycled between 30% and 70% SOC and only a few cycles stretch to either 95% or 20%, then an incorrect estimation of energy capacity can cause the BESS to be charged to higher than intended 95%, or less than intended 20%, due to reduction in energy capacity. The battery cells of a BESS storage battery also degrade faster than usual if they are stored at either high or low SOC limits, and if the temperature during storage is high.

Field data collected during operations of the BESS can be used to provide an accurate estimation of storage battery SOC and overall state of health (SOH) of the BESS storage battery in between calibrations. Battery Management Systems (BMS) do not make accurate estimates of battery cell SOC using field data generated during BESS operations, between calibration cycles. Accurate BESS SOH and energy capacity estimation would also guide early maintenance, which ensures the battery operates in a safe range for measured operating voltage or estimated SOC.

A battery energy control systems (BECS) can be used to schedule BESS operations charge and discharge cycles to meet multiple use cases. The BECS may also be tasked to provide control of power from a BESS to an electrical grid or a microgrid. The BECS can provide look ahead operations that use a forecast of different variables that affect the operation of the BESS. For example, such as power generation, power demand, cost of power from different power sources at various times of day, time of use tariff from grid, cost of peak power due to demand charges or lower cost power from renewables and even higher cost power from a diesel or gas turbine generators.

The BECS requires knowledge of all economic costs associated with every source of power required to charge the BESS. It also needs to know the economic cost associated with BESS cycles. More specifically, the BECS needs knowledge of the cost associated with degradation of the BESS cells when the BESS is either charged from another source of power, or discharged to meet different loads at another time, including when it is idled at some other time for a short or long duration. Accurate estimation of degradation costs requires a battery prognostics method and system that estimates degradation based on a future schedule that is prepared by an BECS. The degradation and associated costs are considered in an iterative optimization algorithm that is run at the BECS to generate a schedule for charging and discharging the BESS.

Suppliers and manufacturers of battery cells contained in the storage battery of the BESS provide warranty commitments on the maximum degradation at the end of a certain period of operation such as every 6 to 12 months. For example, the degradation in the first year can be around 5%, while in year 2, 3 and 4, it can be around 2.5%. In years 5 and 6, it can be different, and the degradation is most of the time nonlinear, with a higher rate of degradation in the first year, followed by lower degradation over the next few years and a higher rate of degradation in the later years. Detecting the degradation of a battery cell early is more important, as the cell is unlikely to show the typical symptoms associated with long term degradations during the early cycles, except when a cell has lower life due to manufacturing defects or variations that need to be identified early. Subjecting all battery cells of a BESS to highly accelerated lifecycle tests may not be economical as it can degrade more cells in order to identify a small percentage of cells that have manufacturing defects or variations that render them with lower life. If a battery cell is found to be degrading faster than expected, then a user can ask the supplier for early replacements. Until replacements are done, the ECS can schedule such battery taking its higher-than-normal degradation costs into account so that they are not cycled with high charge and discharge currents to also have tighter temperature control when such batteries are cycled at higher C-rate. A warranty tracking system is intended to track all battery cells within the battery modules of the BESS storage battery. The battery module is the lowest replaceable unit in a BESS storage battery, and the tracking of battery cell health becomes important to identify weaker outlier cells within a battery module that may limit the life of the entire battery module. The warranty tracking system provides alerts to users when faster than normal degradation is detected and a higher than normal degradation cost to cycle such battery cells.

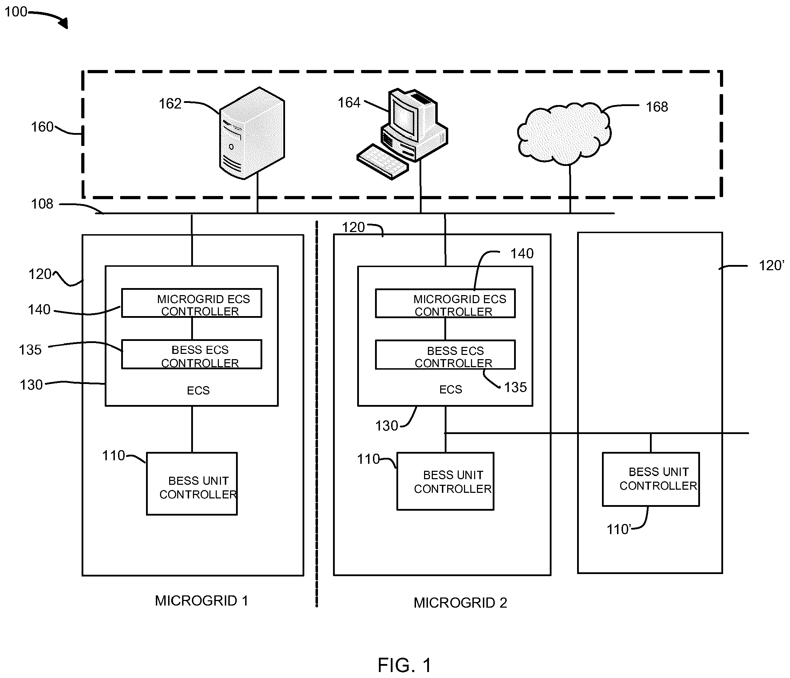

FIG. 1 illustrates an exemplary multi-level control system used in controlling a battery energy storage system (BESS). As illustrated in FIG. 1, the multi-level control system 100 consists of four hierarchical control levels. At the first control level, a BESS unit controller 110 is located in a BESS container 120. The BESS unit controller 110 is used to control the functions of a BESS container 120 and its power conversion assets. Each BESS container 120 is organized as a self-contained package that may at least include a power conversion system, a battery system, a heating ventilation, and air conditioning (HVAC) system, fire protection systems and components and sensors required to monitor the BESS container 120. Each BESS container 120 can be used to power stand-alone deployments of BESS 120 containers and their associated multi-level control system 100 such as for example, a building or a business enterprise or microgrid deployments where a single BESS container 120 or multiple BESS containers 120 can provide power to a neighborhood of homes or to a business district.

At a second control level an energy control system (ECS) 130 is communicatively coupled to one or more BESS unit controllers 110, 110'. The ECS 130 includes a BESS ECS controller 135 that controls the operation of one or more BESS containers 120 and a microgrid ECS (MECS) controller 140. The ECS 130 may be connected to stand-alone BESS container 120 deployments or multiple BESS container 120 deployments or to grid connected multi-container BESS deployments. For example, in FIG. 1, the ECS 130 is shown connected to both BESS unit controller 110, as well as BESS unit controller 110' of BESS container 120'.

The MECS controller 140 comprises a third control level of the multi-level control system 100. The MECS controller 140 is communicatively coupled to the BESS ECS controller 135 and manages alternate power generation assets such as for example, solar, wind, hydroelectric power that may be connected and available on the grid for use by the BESS container 120. The MECS controller 140 is arranged to provide the alternate power capabilities to either a stand-alone BESS container 120 deployment or to multiple microgrid connected BESS container deployments.

A fourth control level of the control system 100 includes a virtual power plant (VPP) 160. The VPP 160 is comprised of distributed small and medium-scale power generating units, loads and energy storage systems, that when aggregated and coordinated using software, performs functions equivalent to a centralized physical power plant. A software operating program executing on, for example, a server 162, functions as a controller that controls the VPP 160. The VPP 160 further includes an operator station 164 and an interface to the cloud 168. The server 162 may be any device that provides resources, data, services or software programs to other processing devices or clients over a network. The operator station 164 may be any computing device that provides functions for power plant operations and monitoring including display of graphics such as diagrams, systems, BESS container 120 deployments and data to a user or operator. The operator station 164 may also receive input from the user or operator to adjust or enter configurable parameters for the BESS unit controller 120, BESS ECS controller 135 and the MECS controller 140. The cloud 168 may be any computing device or technology that delivers services through the internet, including information, data storage, servers, access to databases, networking, and software. The VPP 160 can control multiple BESS containers 120 connected to the VPP 160 through a communication network 108. The VPP 160 as shown in FIG. 1 controls BESS containers 120, 120' in multigrid deployments such as the microgrid 1 and microgrid 2 illustrated in FIG. 1.

The BESS unit controller 110 is tasked to provide for the safe and reliable operation of a BESS container 120. The BESS unit controller 110 monitors the operation of a BESS container 120 preventing operations during fault conditions, shutting down a faulty subsystem and/or sending notifications and alarms to operator station 164 or to mobile device 240. Alarms may be sent using different priority levels if a component, sensor, or subsystem of the BESS unit container 120 fails or becomes faulty. The BESS unit controller 110 interfaces with all the subsystems within a container such as a power conversion system, battery system, HVAC subsystems, fire protection systems etc. The major components of the BESS unit container 120 include the BESS unit controller 110, battery racks 305 housed within the BESS container 120, a power container 310 housed on a separate transportable skid, and the ECS 130.

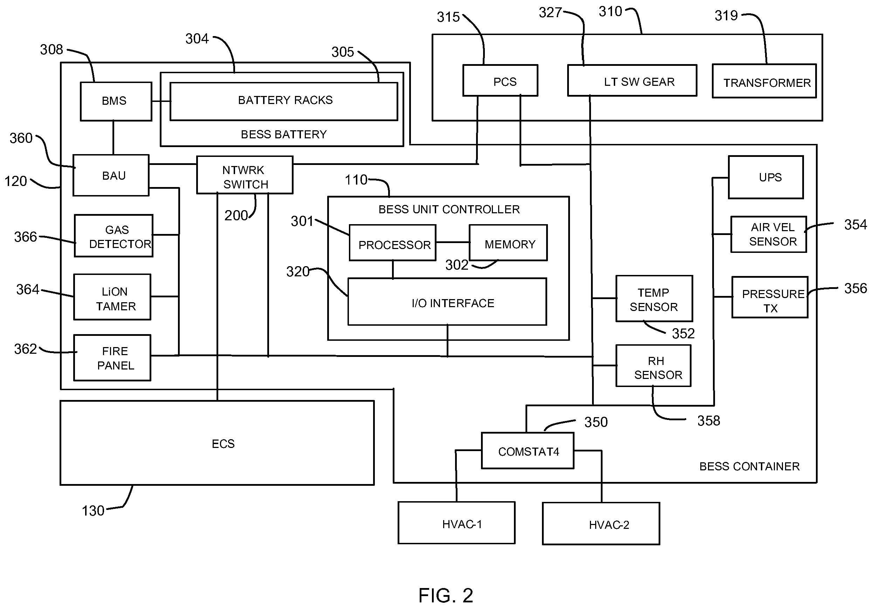

As shown in FIG. 2, the BESS unit controller 110 is comprised of at least one processor 301, at least one memory device 302, and at least one I/O interface 320. The processor 301 executes instructions that may be loaded into memory 302. The processor 301 may include any suitable number(s) and type(s) of processing or other devices in any suitable arrangement. Example types of processing devices include microprocessors, microcontrollers, digital signal processors, field programmable gate arrays, application specific integrated circuits, and discreet circuitry. The processor 301 executes the various programs that operates the various operating modes, states, and safety systems of the BESS container 120.

The memory 302 represents any structure(s) capable of storing and facilitating retrieval of information (such as data, program code, and/or other suitable information on a temporary or permanent basis). The memory 302 may represent a random access memory or any other suitable volatile or non-volatile storage device(s). The memory may also include one or more components or devices supporting longer-term storage of data, such as a ready only memory, hard drive, flash memory, or optical disc.

The I/O interface supports communications with the other systems or devices contained in the BESS container 120. For example, the communications interface 320 could include I/O modules and a network interface card that facilitates communications between the BESS unit controller 110 and the subsystems and sensors of the BESS container 120 as well to levels 2-4 of the BESS control system 100. The I/O unit 320 may support communications through any suitable physical wired communication link or bus. For example, the I/O interface 320 may include an I/O module that can interface control signals to connected HVAC systems HVAC-1 and HVAC-2 through a comstat 4 HVAC controller 350 using a serial digital output. The I/O interface 320 may also include an analog module that can receive 4-20 mAh current loop signals from the various analog sensors located in the BESS container 120, such as for example, temperature sensor 352, air velocity sensor 354, pressure sensor and transmitter 356 and the relative humidity (RH) sensor 358. The I/O interface 320 also includes an Ethernet interface for bidirectional communication of control signals and data between a battery administration unit (BAU) 360, the ECS 130 and the various fire safety devises such as the fire detection panel 362 and LiON-tamer 364 and gas detector 366, that detects hydrogen gas that may be generated by lithium batteries as they degrade.

The BESS container 120 includes a storage battery, hereinafter referred to as a BESS battery 304. The BESS battery is comprised of multiple battery modules that are electrically interconnected in series and also in parallel. Each battery module comprises of a plurality of battery cells that are also electrically interconnected in series and also in parallel. The multiple battery modules form multiple battery racks 305 stacked within the BESS container 120. Charging and discharging of BESS battery 304 considers the state of charge (SOC) of the battery modules comprising the BESS battery 304 and ensures that charging does not cause increased power dissipation and heating of the individual cells.

Each BESS container 120 is also connected to a power container 310 communicatively coupled to the BESS container 120. The power container 310 typically includes a bidirectional power conversion system (PCS) 315 and its associated components. The PCS 315 converts an AC voltage supplied by the grid, to DC voltage to charge the BESS storage battery or converts the DC power provided by the BESS battery 304 battery racks 305 into an AC voltage providing electrical power to a connected building, dwellings or to a microgrid. The power container 310 may also include low tension (LT) switch gear 327 and transformer 319 to provide electrical power to low tension or low voltage electrical networks.

The BESS unit controller 110 is further operatively connected to the BESS ECS controller 135 of ECS 130. The BESS ECS controller 135 acts as a supervisory controller to one or more BESS unit controllers 110. As shown in FIGS. 1 an ECS 130 can control one or more BESS containers using the control network 109. The BESS unit controller 110 of each BESS container 120 gathers the operating parameters of a connected BESS unit 120 and sends the data to its supervising BESS ECS controller 135 for control of the charging and discharging requirements of the BESS container(s) 120. For example, BESS ECS controller 135 computes the power reference for each PCS 315 attached to one or more BESS container 120, considering the current operational state of a BESS container 120, such as alarms related to failure of subsystems or faults and diagnostics data of critical subsystems, such as the battery racks 305, PCS 315 and HVAC.

When multiple BESS containers 120 and their power containers 310 are used at any site to provide electrical power at a stand-alone site or microgrid, the BESS ECS controller 135 determines the total charging power or discharging power that should be provided to the deployment and distributes the charging or discharging power requirements to the connected multiple BESS unit controllers 110. For example, the BESS ECS controller 135 computes a power reference for the different PCS 315 units, considering the power capacity of each PCS 315 and the power and energy capacity of the BESS container 120. The power and energy capacity of the BESS container 120 is determined by the number of battery racks 305 in operation. When there are multiple BESS containers 120 deployed at stand-alone site, or at a microgrid site, and the multiple BESS containers 120 are connected to a single PCS 315, the deployment however having a capability of more than a single PCSs 315, then the BESS ECS controller 135 computes power reference for all the PCSs 315 that are available to be connected. The BESS ECS controller 135 communicates the state of the plurality of BESS containers 120 to the next level in the BESS control hierarchy, the MECS controller 140. The BESS ECS controller 135 also communicates the available power reference for a PCS 315 to the BESS unit controller 135, associated and connected to a BESS container 120.

In installations having multiple BESS containers 120 the balancing state of the battery racks 305 for one BESS container 120 with the battery racks of another BESS container is not taken in account by either the BMS 308 or the battery administration unit 360 of the BESS container 120. In such multiple BESS container 120 installations the BESS ECS controller 135 manages each BAU 360 of a BESS container 120 through its respective BESS unit controller 110, via network switch 200. The ECS controller 135 provides a state of charge (SOC) balancing through the BAU 360 to the BMS 308 of each of the battery racks 305 of the multiple connected BESS containers 120.

Additionally, the BESS ECS controller 135 is arranged to consider the microgrid loads that the BESS container 120 needs to power and manages the available power containers 310 to draw sufficient power from the battery racks 305 of each BESS container 120 so as not to over-discharge anyone of the battery racks 305. When multiple BESS containers 120 and PCS 315 are used at any deployment site, the BESS ECS controller 135 is further arranged to determine the total charging power or discharging power for the multiple BESS containers 120. The BESS ECS controller 135 controls the distribution of the charging power to the multiple BAU units 360 and their associated battery racks 305 to the multiple BESS power containers 310.

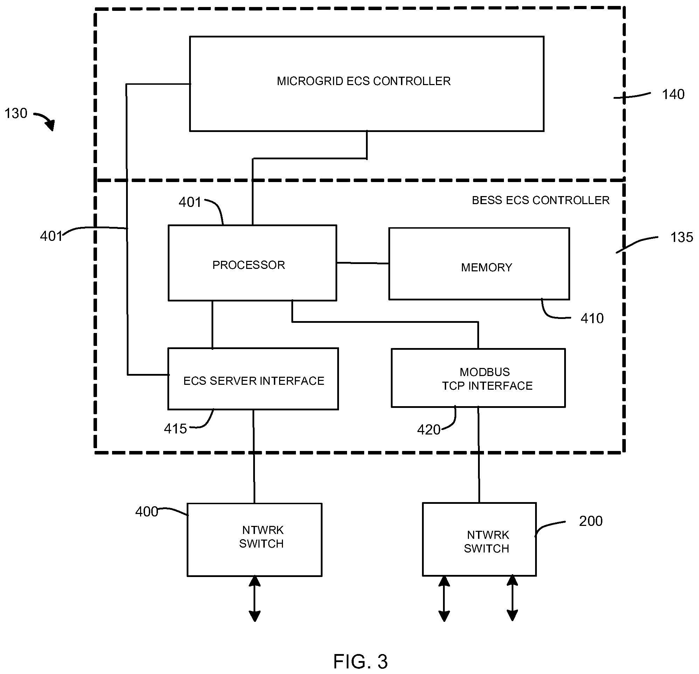

FIG. 3, illustrates the components of an exemplary ECS 130. The ECS 130 is comprised of the BESS ECS controller 135 and the MECS controller 140. The BESS ECS controller 135 and the MECS controller 140 are logically separate, however, they may be located on and execute within a common physical hardware/software controller or communicatively coupled to different physical hardware/software controllers. The BESS ECS controller 135 is comprised of at least one processor 401, at least one memory device 410, at least one ECS server interface 415 and at least one MODBUS TCP interface 420. The processor 401 executes instructions that may be loaded into memory 410. The processor 401 may include any suitable number(s) and type(s) of processing or other devices in any suitable arrangement. Example types of processing devices include microprocessors, microcontrollers, digital signal processors, field programmable gate arrays, application specific integrated circuits, and discreet circuitry.

The memory 410 represents any structure(s) capable of storing and facilitating retrieval of information (such as data, program code, and/or other suitable information on a temporary or permanent basis). The memory 410 may represent a random access memory or any other suitable volatile or non-volatile storage device(s). The memory may also include one or more components or devices supporting longer-term storage of data, such as a ready only memory, hard drive, flash memory, or optical disc.

The processor 401 executes the various programs stored in memory 410 that operates the BESS ECS controller 135 to provide references for power balancing between BESS containers 120 and the PCS 315 attached to the BESS containers 120. The programs further operate to distribute the power balancing references to the BESS unit controllers 110. The BESS ECS controller 135 also takes inputs on the number of battery racks 305 that have been committed within a BESS battery 304 of a BESS container 120 in the calculation of power reference for the BESS containers 120. The BESS ECS controller 135 executes programs that calculate energy balancing taking into consideration the aggregate SOC and cycle count of different BESS containers 120 that have the same or a different number of battery racks 305 available for discharge or cut-out and not available for use.

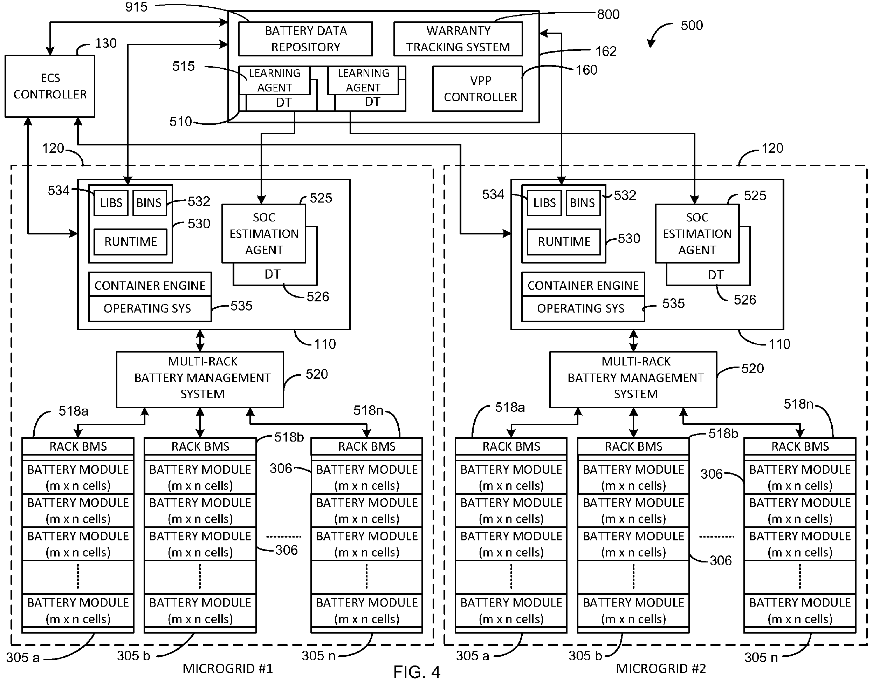

The ECS server interface 415 provides a communication portal to network 108 through network switch 400 and firewall 220 to the VPP 160 using a DPN3 or MQTT protocol. This communication portal from server interface 415 serves as the BESS container 120 connection to VPP 160 and level 4 of the BESS control system 100. As is seen in FIG. 4, the MECS controller 140 also includes a direct communication connection to the ECS server interface 415 through a bidirectional line 401 that allows the MECS controller 140 to have direct access to the VPP 160. The MECS controller 140 can be located and contained in the ECS 130, however, as explained above, it is logically separate from the BESS ECS controller 135.

The MODBUS TCP interface provides a Modbus TCP/IP communication portal providing Ethernet intranet communication between the BESS ECS controller 135 and BESS unit controllers 110 in either single or multiple BESS container 120 deployments using network switch 200.

The ECS 130 functions as a DNP3 outstation that interworks with a DNP3 master running on server 162 on the VPP 160. The BESS ECS controller 135 allows selection of four different operating modes to provide power reference for the connected BESS unit controllers 110. The operating modes include: (1) a configurable power reference configured for a test mode (this mode is used mostly for test and certifications); (2) a local human machine interface (HMI) configuration of a schedule for charging or discharging according to a power reference configured by the BESS ECS controller 135. The HMI running at the operator station 164 or a handheld mobile device (not shown); (3) a local HMI configuration of use cases that the BESS battery 304 needs to support and a configurable schedule for the use cases of the HMI configuration; and (4) a charge / discharge schedule downloaded from a remote operation center from the cloud 168. Operating mode 3 enables operation of the BESS control system 100 within a microgrid, where function blocks running algorithms for each of the use cases generates a power reference for the PCS 315 to manage charging or discharging of the BESS battery 304.

The VPP 160 performs centralized co-ordination of distributed microgrids. The VPP 160 is tasked to calculate reference power for either supplying power to the microgrid or drawing power from a main grid to which multiple microgrids are connected. The MECS controller 140 may receive an operating schedule from the VPP 160. For example, a schedule for the exchange of power between a microgrid and the grid, or a schedule of grid electricity prices associated with power import or export in situations where the import and export of power has a difference in a price setpoint, or simply a schedule of use cases for which one or more BESS containers 120 along with generation assets and loads are to be committed. For example, renewable smoothing for export between 09:00 and 12:00 hours, frequency regulation support between 12:00 and 17:00 hours and grid peak demand support between 17:00 and 20:00 hours.

With information from the VPP 160, the MECS controller 140 computes a schedule for charging or discharging one or more BESS containers 120. The MECS controller 140 computes the schedule for charging or discharging considering the schedule provided by the VPP 160, but also the local generation loads, frequency, and voltage within a microgrid.

When computing schedules, the MECS controller 140 uses look ahead operations to forecast local power generation and demand/loads. When local power generation is controllable, such as for example using a diesel generator, the forecast of such local power generation is the same as the schedule for the commitment of controllable generators. When power generation is not controllable and variable and intermittent in nature such as using renewable power generation sources, a forecast is computed using historic time series data as well as inputs from weather stations and other sources of weather forecasting provided by the VPP 160. If there is a deviation, then the deviation needs to be accounted for and the schedules revised. For example, in a look ahead operation that uses a forecast, a short-term accurate forecast is necessary because charging or discharging a battery takes a finite amount of time and depends on the rate at which level the battery is providing energy or its C-Rating. For instance, it takes approximately 1 hour to fully charge a 1C rated battery system while it takes 4 hours to fully charge or discharge a 0.25C rated battery system. Hence for a 0.25C rated battery system, in order to meet a grid peak support use case at any given time, battery charging should have started at least four hours before the time at which battery is intended to be discharged using PCS 315. Even for a 1C rated system, where it is feasible to charge with high power, but charging with a higher power may attract higher demand charges, or alternatively may cause a larger rise in battery temperature that can cause it to degrade faster, it may be necessary to charge with a lower power. A lower charging power would mean charging for a longer duration and a forecast for at least that duration is necessary to ensure battery is charged when it is required to discharge the stored energy.

The VPP 160 is further tasked in the balancing of the supply and demand for power in multiple microgrids using economic optimization objectives, peak demand forecasts, and renewable energy generation forecasts. For example, the VPP 160 may receive information from the cloud 168 from energy trading data that generates market bids and market clearing prices from an energy market operator. The information may be used on demand as information response signals to the MECS controller 140 to reduce, for example, diesel electrical generating sources over other generating sources due to the higher costs of diesel fuel.

A system 500 for detecting the degradation of battery energy storage systems of the present disclosure is shown in FIGS. 4-5. The system and method detects battery degradation of a BESS battery 304 and any economic costs associated with a BESS battery degradation that may impact future cycles of the battery. The BECS is comprised of a BESS digital twin (DT) 510 installed on an energy control system of a SCADA server 162 along with the VPP 160. A digital twin is defined for the purposes of this disclosure, as a virtual model that uses real-time data to simulate the behavior of an asset or system and its operations including overseeing the performance of the asset or system to identify potential faults and make better-informed decisions about operations and lifecycle performance. The energy control system SCADA server 162 schedules future charge/discharge cycles for the BESS battery 304 utilizing the physical state of the battery racks 305a, 305b through 305n contained in battery 304. Battery operational data is collected from the BESS containers 120 installed in the field, for each battery rack installed in a BESS container 120. The battery operational data collected includes for example, current, voltage temperature, SOC of the battery modules 306 of battery racks 305a, 305b, 305n. The battery operational data is coupled to degradation estimation models in a learning agent 515. The degradation estimation models are continuously improved using any new data collected from the BESS containers 120 in the field. Accurate estimation of SOC requires considering the reduced energy capacity of the battery racks between SOC calibration test cycles when batteries are not fully cycled. The learning agents 515 use physics-based models parametrized using data driven methods of past time-series data of voltage, current and temperature to train recurrent neural networks. The estimate of battery degradation reduces the need to run or even completely avoid calibration tests, which in turn reduces the down time of the BESS for such tests, thereby increasing the availability of the BESS to the microgrid. The prognostics for battery degradation and improved battery charge/discharge schedules, improves cost and energy efficiency. The early identification of degradation, even before typical symptoms of degradation are visible, can be used to track warranty of a BESS storage battery.

BESS unit controller 110 receives battery module 306 and battery rack 305a, 305b, 305n level data from a multi-rack battery management system 520 sent from a battery rack BMS 518a, 518b, 518n associated with battery racks 305a, 305b, 305n, respectively. The data read includes voltage, current, temperature, SOC, and SOH of all the battery cells contained in each battery rack modules 306. While voltage, current and temperature are measured directly from sensors attached to battery cells, SOC and SOH are inferred by the battery management system 520. Estimation of SOC and SOH by the BMS 520 can be inaccurate if the battery has not gone through calibration tests or full cycles of battery charge and discharge. Battery prognostics models that are based on hybrid physics and neural networks that learn from the battery operational data, solve the problem of accurate estimation of battery SOC and SOH using data made from partial battery cycles in between calibration tests and full cycles. The energy control system SCADA server 162 may also be programmed to avoid full battery cycles to avoid stretching the battery to the limits in order to increase its life.

An SOC estimation agent 525 running in the BESS unit controller 110 uses a DT 526 within a containerized software application executed by processor 301 of the BESS unit controller 110. The containerized software 530 includes all the binaries (BINS) 532 and libraries (LIBS) 534 required to run the SOC estimation agent 525 application in a container run time. The processor 301 also runs a controller 110 host operating system 535. The host operating system 535 in the controller 110 can run multiple container engines. Battery operational data from the battery racks 305a, 305b, 305n and battery modules 306 is sent from each rack BMS 518a, 518b, 518n to the multi-rack battery management system 520. It should be noted that the BESS battery 304 may also be deployed using compact, modular scalable cubed battery cell configurations organized as strings and modules of Lithium Iron Phosphate (LFP) battery cells that are monitored by a cube BMS on a cell, module, and string level, similar to the rack BMS 518a, 518b, 518n shown in FIG. 4.

Battery operational data such as for example, current, voltage, temperature, SOC, and SOH data are periodically collected once during a time interval defined by a user, for example every 15 minutes, the rate of change of parameters are calculated, and if the rate of change of parameters exceeds a configurable threshold, the data collected is sent to a battery data repository 915 hosted on the energy control system SCADA server 162 by the BESS unit controller and the ECS 130. The battery data repository may also be hosted in the cloud 168. The battery data repository 915 aggregates battery data from the multiple BESS containers. A remote or cloud hosted battery data repository 915 is beneficial in enabling newer BESS installations to leverage the data generated by older BESS container 120 installation so that the models can be trained using data generated by the older BESS installations. This provides an improved accuracy of SOC and charge estimations, as more data is collected from BESS containers 120.

The battery data stored in the battery data repository 915 is used for training digital twins associated with and coupled to an individual BESS container 120. For example, a DT parameter learning agent 515 comprising a digital twin 510 would be associated with each BESS container 120. The DT 510 is an aggregation of multiple physical models based on Doyle-Fuller-Newman (DFN) Multiphysics model for battery cells. The parameter learning agent 515 learns from historic time-series data using a recurrent neural network (RNN). The trained digital twin is downloaded to the estimation agent of BESS unit controller 110. The DT 526 running in the BESS unit controller 110 generates real-time estimates for the SOC that are more accurate than the SOC estimates produced by a BESS container BMS 308. This is due to the BESS container BMS 308 not having visibility of data generated by other BESS container 120 deployments and the ability to learn from the data generated by the other BESS containers 120 deployed at multiple microgrids sites controlled by the VPP 160.

The real-time SOC estimates performed inside the BESS unit controller 110 at a microgrid site is useful in generating a short-term schedule for battery charge and discharge cycles based on short term forecasts for power demand, generation, and cost of power from different sources at the microgrid site. However, long-term degradation and reduction in state of health parameters is a much slower process. Hence the health estimates need not be updated as frequently as state of charge estimates and can run centrally over the cloud hosted energy control system computer platform. The energy and power capacity estimated by the model and is used by the SOC estimation agent when battery is not going through full charge and discharge cycles or long after a calibration test was performed.

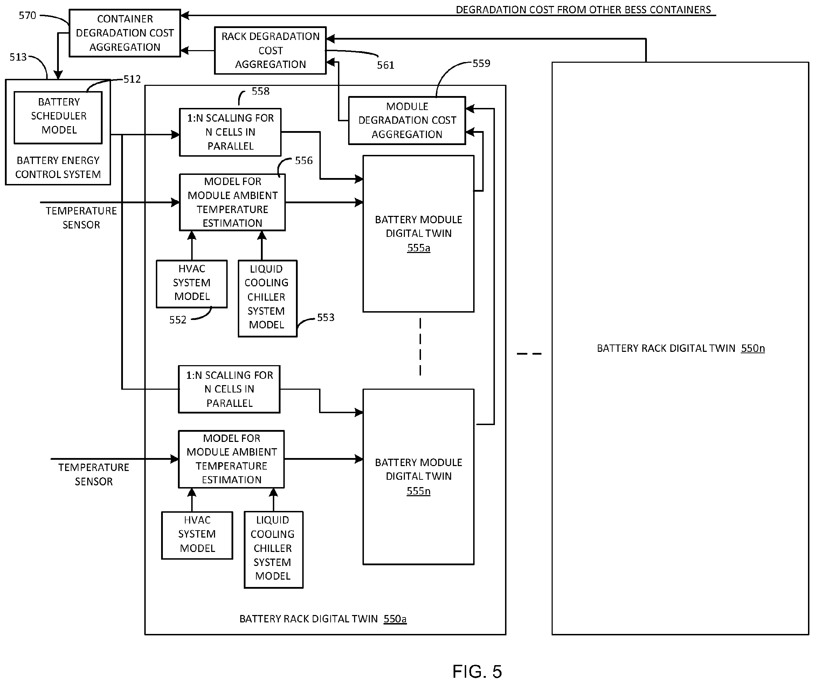

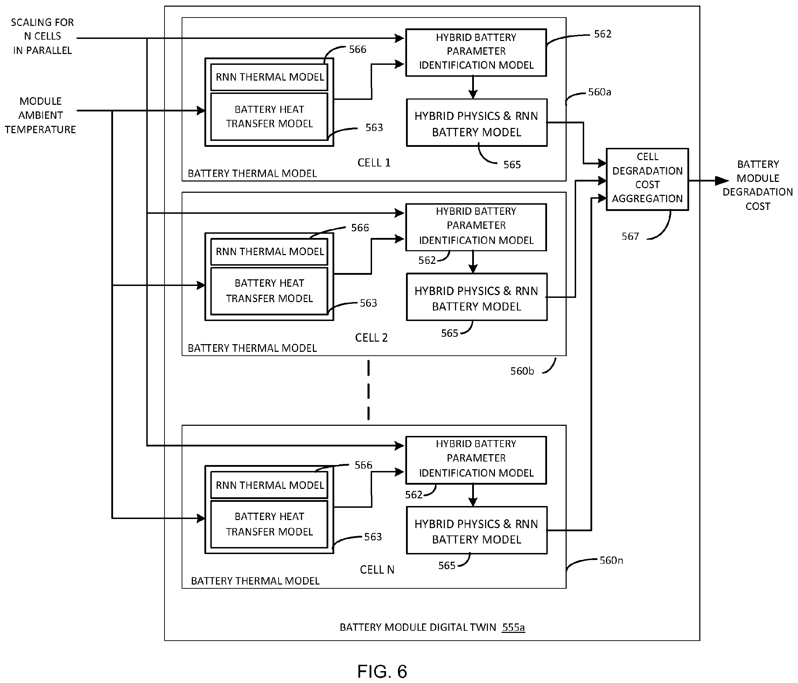

FIGS 5 and 6 illustrate an exemplary embodiment of the DT 526, used for battery scheduling operations for charging/discharging the BESS battery 304. The DT 526 executing in the BESS unit controller 110 is an aggregation of multiple battery rack digital twins 550a - 550n that are associated with each battery rack contained in the BESS battery 304, such as battery racks 305a, 305b, 305n shown in FIG. 3. The multiple battery digital twins also be installed inside of cubes in a cluster of battery cubes that may be connected in parallel to form a BESS battery 304. Each battery rack digital twin 550a, 550n is an aggregation of multiple battery module digital twins that are arranged in series for each battery rack contained in the BESS battery 304. Each battery rack digital twin 550a, 550n is identical in its functional structure and for the purpose of clarity, only the system elements of the battery rack digital twin 550a is illustrated in FIG. 5.

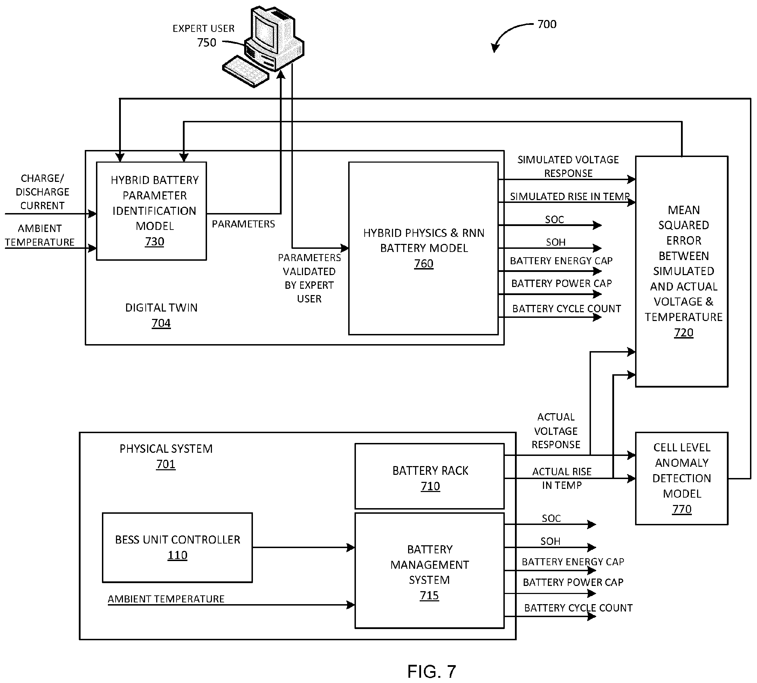

Each battery rack digital twin 550a is an aggregation of battery module digital twin 555a, 555n which is a further aggregation of multiple battery cell digital twins 560a, 560b, 560n, shown at FIG. 6. The battery cell digital twins 560a, 560b, 560n are arranged in series and parallel for each battery module 306. Battery cell digital twins 560a, 560b, 560n, are the smallest unit used in a hybrid physics and RNN battery model 565. Doyle-Fuller-Newman Multiphysics model is one of the options for the physics-based model of a battery cell. The data driven RNN-based model within 565 is also used to estimate the degradation in energy capacity and power capacity of the battery cells of the BESS battery 304. The RNN estimate is used if a physics model parameter estimation fails or if the parameter estimates are rejected by a human expert because the parameter estimation model requires retraining with input from a human expert user. Expert user review and validation of battery model parameters will be explained in the discussion of FIG. 7.

The cell digital twins 560a, 560b, 560n use a battery thermal model to generate an estimate of a battery cell's surface temperature. The battery cell surface temperature estimate is input to a cell parameter identification model 562. The battery thermal model includes a battery cell heat transfer model 563 that is a lumped element model that generates an estimate of heat generation and heat transfer in a single battery cell due to currents flowing in either direction at different cell voltages or SOC levels. The battery thermal model also includes an RNN thermal model 566 that is trained using the past temperature time series data.

Battery module ambient temperature is an input to the battery heat transfer model 563 of the battery thermal model for each battery thermal model digital twin 560a, 560b, 560n. The module ambient temperature is derived from an ambient temperature estimation model 556, shown on FIG. 5. The output of an ambient temperature estimation model 556 is coupled to a battery heat transfer model 563 and is used to estimate a battery cell surface temperature. Battery cell current is estimated by 1:N scaling module 558 by dividing the module current by a scaling factor 1: N, where N is the number of parallel cell groups that are arranged within a battery module. The estimated current output from module 558 is coupled to the hybrid battery parameter identification model 562. Forced air cooling using a heating, ventilation, and air conditioning (HVAC) unit and liquid cooling using chillers that may be installed in the BESS container 120 to cool the BESS battery 304 battery cells is also considered by the ambient temperature estimation model 556. A model for an HVAC system 552 and liquid cooling chiller system 553 are used as inputs to refine the ambient temperature data from temperature sensor inputs installed near each battery module 306.

The energy and power capacity estimate generated by the RNN model due to being trained using historic data from multiple BESS containers 120 installations of the hybrid physics & RNN battery model 565 provides a more accurate capacity estimate than the estimate from the Multiphysics model that was not been parametrized correctly. This energy and power capacity estimate by the RNN model is used in the interim, until parameter estimation is improved with inputs from a human expert user, to reflect the physical condition of the BESS battery 304. The parameter identification model 562 uses data driven methods including the use of neural networks to estimate the physical parameters of the BESS batteries. As each parameter is different, a different model is used for each parameter. Only parameters that have good sensitivity and identifiability are estimated using this method. Parameters that have low sensitivity are left out to reduce the computation needs and they are fixed in the physics model and do not change during the life of the battery. Look up tables are used for parameters that have low identifiability but have good sensitivity to age and cycle induced degradation.

Cost aggregation modules calculate the total cost of degradation of the BESS battery 304 at different levels of the BESS system. The battery module 306 is considered the lowest replaceable unit of a BESS battery 304. The aggregate cost of degradation of a battery module 306 is not the sum of the degradation costs of the individual cells, rather, the battery module degradation cost is calculated by scaling the cost of degradation of each in the battery cells of a battery module that has the highest or maximum degradation within the battery module by a scaling factor that is equal to the number of battery cells within a battery module. The data driven RNN-based model 565 is used to estimate the degradation in energy and power capacity available from each cell of a battery module 306 and the degradation scaling factor applied to a cell degradation cost aggregation module 567.

As all battery modules are replaceable, the cost of degradation of a battery rack 305a, 305b, 305n is the cost of degradation of all the battery modules 306 that are connected in series within a battery rack and this cost is applied from each battery cell degradation cost aggregation module 567 to a battery rack degradation cost aggregation module 559. Similarly, the cost of degradation of the BESS battery racks 305 in a BESS battery 304 in a BESS container 120, or a cluster of cubes, is the sum of the cost of degradation of multiple racks within the BESS container 120 or the cluster of cubes. The total degradation cost of the BESS container 120 from all of the battery racks 305a, 305b, 305n are coupled to a BESS rack degradation cost aggregation module 561. The BESS container degradation cost aggregation module 570 also receives as an input a total degradation cost from other BESS containers 120 deployed in the field. The output of the BESS container degradation cost aggregation module 570 is coupled to the battery energy control system 513, where the battery energy control system 513 runs energy cost and carbon optimization calculations. The battery energy control system 5 considers the cost of degradation in the schedule generation algorithm of a battery scheduler model 512 to minimize the total weighted cost of energy to include the battery degradation cost associated with charging and discharging of the BESS battery 304. The battery energy control system 510, using the battery scheduler model 512 can also perform opportunistic full cycles for auto-calibration in the energy optimization schedules over a period of time, which can eliminate down time for calibration testing of the BESS battery 304.

Fig. 7 illustrates schematically an embodiment 700 for updating the BESS battery model parameters based on data generated during battery charge and discharge cycles that uses an expert user to review and validate the battery model parameters. The physical BESS system 701 of a BESS container 120 comprises battery modules 306 installed in battery racks 305a, 305b, 305n within the BESS container 120. The battery rack of a BESS container 120 is shown as a single rack 710 in FIG. 7 for simplification. The battery modules of battery rack 710 are controlled by a hierarchical BMS 715, which in turn is under the control of a BESS unit controller 110 through the PCS 315 associated with the BESS container 120. BESS unit controller 110 receives a power reference from the BESS ECS controller 130 and validates the power reference with respect to available power and energy capacity of the BESS battery 304 installed at the microgrid site. The BESS ECS controller 130 couples the power reference to the PCS 315 that either draws a discharging current from the BESS battery 304 or supplies a charging current to charge the BESS battery.

In response to the charging or discharging current, the battery terminals of the battery cells contained in battery rack 710 produce a change in the voltage at the battery terminals, which represents the actual voltage response of the battery to the charging or discharging current. The current flowing through the battery cells of the battery rack 710 also generate heat that causes temperature to rise, which is termed as an actual rise in temperature of the battery cells of the battery rack 710. The BMS 715 calculates an estimated SOC, SOH, cycle count, battery energy capacity and battery power capacity for the battery rack 710 using internal models located in the BMS 715. The estimates from the BMS 715 are only accurate immediately after the SOC calibration, which comes with down time for the BESS system.

A battery digital twin 704 may be used to increase the time period between calibration tests. This reduces the down time of the BESS container 120 and increases the availability of BESS for its intended use cases. It achieves this objective by using the digital twin 704 simultaneously along with the physical system 701, to generate a more accurate estimate for SOC, SOH, battery energy capacity, battery power capacity and cycle count. The digital twin 704 considers all the field data that is generated from BESS operations, and field data from multiple BESS container deployments downloaded to the ECS controller 130 from the VPP controller 160. The digital twin 704 produces a simulated voltage response and a simulated rise in temperature that is as close as possible to the actual voltage response and actual rise in temperature derived by the physical system 701.

A mean square error model 720 receives the simulated and actual voltage response, and the simulated and actual rise in temperature and calculates the mean square error between the simulated and actual quantities. The output of the mean square error is input to a hybrid battery parameter identification model 730. Parameter identification model 730 uses data driven methods including neural networks to generate estimates of the parameters, or more specifically changes in battery parameters based on actual charge discharge current and ambient temperature input to the parameter identification model. The parameter identification model 730 for each parameter is different and is derived considering the identifiability and sensitivity of the parameter to changes in battery state estimations. The battery model parameters are listed in TABLE 1 below.

The parameters generated are uploaded to a human expert user 750 for analysis. The human expert user 750 analyzes and confirms the changes in the battery parameters before they are downloaded to a hybrid physics & RNN battery model 760. The battery model 760 is complemented by a completely data driven RNN model that is trained with past time series battery operational data that generates as outputs an estimate for simulated voltage response, simulated rise in temperature, SOC, SOH, and cycle count during partial cycles of the BESS battery 304. The human expert user 750 may decide to choose the actual estimation of battery state from the physical system 701 as opposed to estimation of battery state derived by the battery model 760 of the digital twin 704, when there is evidence of inaccuracy of model parameters, or when parameter identification models need to be improved. Templates for parameter identification models are provided to the expert user 750 to experiment with models for parameter identifications. Such templates will include options to formulate algebraic equations, differential algebraic equations, ordinary differential equations, and expression trees to formulate parameters.

As each parameter is different, a different model is used for each parameter. Only parameters that have good sensitivity and identifiability are estimated using this method. Parameters that have low sensitivity are left out to reduce the computation needs and they are fixed in the physics model and do not change during the life of the battery. The parameter identification model 730 model parameters with high sensitivity and identifiability are tabulated in TABLE 1 below.

TABLE 1

| Model Parameter | Symbol & Governing Equations | Unit |
|---|---|---|
| Anode Thickness | $L_p$ | $\mu m$ |
| Cathode Thickness | $L_n$ | $\mu m$ |
| Solid Phase Thickness | $L_s$ | $\mu m$ |
| Anode Surface Area | $A_p \quad Q_{\text{out}}^{\max}/Q_1 \; = \; A/A_1$ | $m^2$ |
| Cathode Surface Area | $A_n \quad Q_{\text{out}}^{\max}/Q_1 \; = \; A/A_1$ | $m^2$ |
| Solid Phase Surface Area | $A_s \quad Q_{\text{out}}^{\max}/Q_1 \; = \; A/A_1$ | $m^2$ |

(continued)

| Model Parameter | Symbol & Governing Equations | Unit |
|---|---|---|
| Radius of Anode material particle | $R_p^+$ | μm |
| Radius of Cathode material particle | $R_p^-$ | μm |
| Active particles volume fraction in Cathode | $\varepsilon_{s,n}$ | |

TABLE 1 (Continued)

| Active particles volume fraction in Anode | $\varepsilon_{s,p}$ | |
|---|---|---|
| Electrolyte volume fraction in Anode | $\varepsilon_{e,p}$ | |
| Electrolyte volume fraction in separator | $\varepsilon_{e,sep}$ | |
| Maximum Li$^+$ concentration | $C_s^{p,n,se}$ $$\frac{\partial C_{s,k}}{\partial t} = \frac{D_{s,k}}{r^2}\frac{\partial}{\partial r}\left(r^2\frac{\partial C_{s,k}}{\partial r}\right)$$ with boundary conditions $$\frac{\partial C_{s,k}}{\partial r}\bigg|_{r=0} = 0, -D_{s,k}\frac{\partial C_{s,k}}{\partial r}\bigg|_{r=R_s} = \frac{j_{\mathrm{Li},k}}{a_{s,k}F}$$ | mol cm$^{-3}$ |
| Average electrolyte concentration | $C_e$ $$\varepsilon_e\frac{\partial C_e}{\partial t} = \frac{\partial}{\partial x}\left(D_e^{\mathrm{eff}}\frac{\partial C_e}{\partial x}\right) + \frac{1-t_+}{F}j_{\mathrm{Li}}$$ | mol cm$^{-3}$ |
| Maximum solid phase concentration in cathode | $C_{s,n}^{max}$ | mol cm$^{-3}$ |
| Maximum solid phase concentration in anode | $C_{s,p}^{max}$ | mol cm$^{-3}$ |

TABLE 1 (Continued)

| Stoichiometry at 0% state of charge in Cathode | N0% | |
|---|---|---|
| Stoichiometry at 100% state of charge in Cathode | N100% | |
| Stoichiometry at 0% state of charge in Anode | P0% | |
| Stoichiometry at 100% state of charge in Anode | P100% | |
| Li-ion diffusion coefficient in electrolyte | $D_e$ | m$^2$ s$^{-1}$ |
| Li-ion diffusion coefficient in Cathode | $D_{s,n}$ | m$^2$ s$^{-1}$ |
| Li-ion diffusion coefficient in Anode | $D_{s,p}$ | m$^2$ s$^{-1}$ |
| Solid phase conductivity | $\sigma_s^p$ , $\sigma_s^n$ | μm |
| Li transference number | $t_+^0$ | |

TABLE 1 (Continued)

| Resistivity of film layers (including SEI) | $R_f$ | Ω |
|---|---|---|
| Open circuit potential | V | V |
| Reaction flux at the solid particle surface | $j$ $$j_{Li,k} = a_{s,k}i_{0,k}\left(\exp\left(\frac{\alpha_k F}{RT}\eta_k\right) - \exp\left(\frac{(\alpha_k-1)F}{RT}\eta_k\right)\right)$$ | **mol** cm$^{-1}$s$^{-1}$ |
| Exchange (electrolyte and | $i_e$ $$i_{0,k} = k_0 C_e^{\alpha_k}(C_{s,k}^{\mathrm{max}} - C_{s,k}^{\mathrm{surf}})^{\alpha_k}(C_{s,k}^{\mathrm{surf}})^{1-\alpha_k}$$ | A cm$^{-2}$ |

(continued)

| Resistivity of film layers (including SEI) | $R_f$ | $\Omega$ |
|---|---|---|
| solid) current density | | |
| Charge transfer coefficients in cathode | $\alpha_c$ | |
| Charge transfer coefficients in anode | $\alpha_a$ | |
| Kinetic constant in cathode | $k_{0,n}$ | $A \cdot m^{5/2} mol^{-3/2}$ |
| Kinetic constant in anode | $k_{0,p}$ | $A \cdot m^{5/2} mol^{-3/2}$ |
| Electrical conductivity in cathode | $\sigma_n$ $\quad -\sigma_n^{\text{eff}} \dfrac{\partial \phi_{s,n}}{\partial x}\bigg|_{x=0} = \dfrac{I_{\text{app}}}{A}$ | $S \cdot m^{-1}$ |

TABLE 1 (Continued)

| Electrical conductivity in anode | $\sigma_p$ $\quad -\sigma_p^{\text{eff}} \dfrac{\partial \phi_{s,p}}{\partial x}\bigg|_{x=L} = \dfrac{I_{\text{app}}}{A}$ | $S \cdot m^{-1}$ |
|---|---|---|

A cell level anomaly detection model 770 detects any abnormal values in cell current, voltage, or temperature. A higher-than-normal cell current may be indicative of a physical defect that could lead to a short circuit, which may be catastrophic if undetected. A deviation in cell voltage, especially when charging or discharging, may be indicative of a higher cell impedance, which is due to degradation. If such degradation remains undiagnosed it can lead to higher temperatures that can further aggravate degradation. A higher cell temperature, especially near limits of SOC may be indicative of reduced energy capacity, which would require calibration of SOC. If undetected, such deviations can accelerate degradation, that is preventable if detected early. I The cell level anomaly detection model identifies outliers in cell data and raises alarms for user intervention to update model parameters related to the outlier cells. This provides an efficient means for identifying voltage, current and temperature data at the cell level.

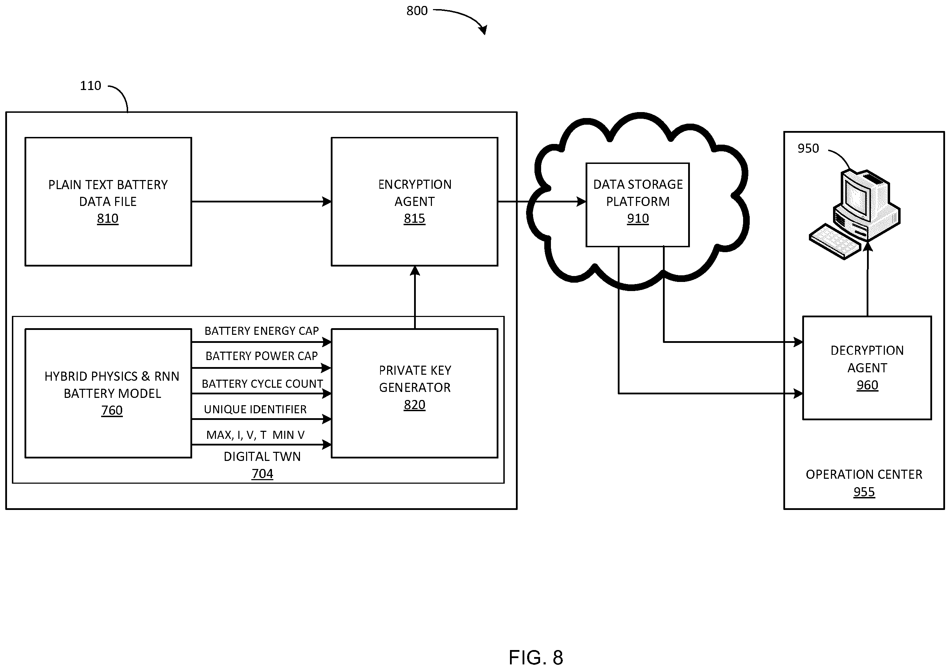

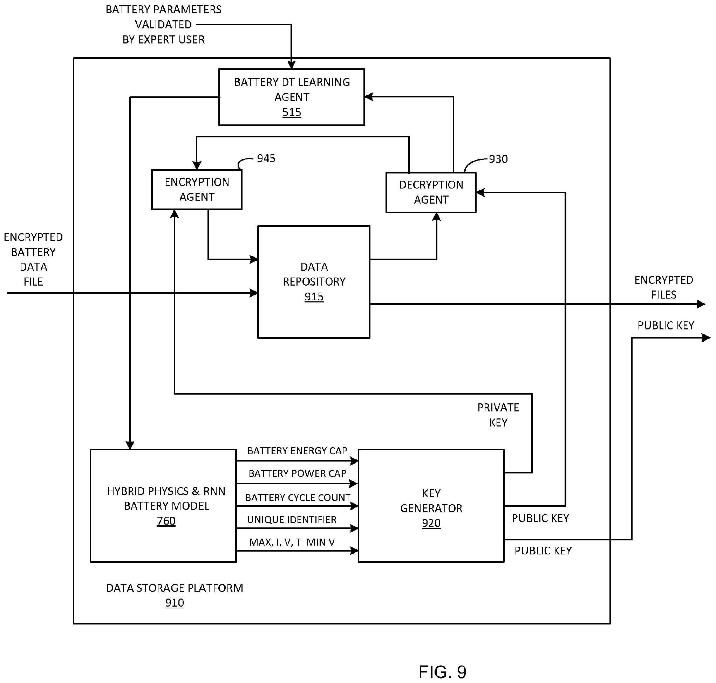

FIGS 8 and 9 illustrate an embodiment of the present disclosure of a warranty tracking system 800 used to protect the integrity of BESS battery data for warranty tracking of the BESS battery 304. The BESS warranty tracking system 800 uses battery data such as current, voltage and temperature along with reports for faster than expected degradation over any given time period for a BESS system battery, such as BESS battery 304. The warranty tracking system 800 uses the actual BESS battery data stored in a plain text file 810 in the BESS unit controller 110. The battery data contained in the plain text file 810 is encrypted by an encryption agent 815 using a private key generated by a private key generator 820. The private key is generated by the digital twin 704 using the hybrid physics & RNN battery model 760 using simulated battery data derived from actual battery data as described in the embodiment shown in FIG. 7. The private key generator 820 receives the simulated battery data from the digital twin 704. The battery data includes energy capacity, power capacity, cycle count, a unique identifier for the physical battery, maximum values for current (MAX 1), voltage (Max V), and temperature (MAX T) and minimum value for voltage (MIN V). The plain text file containing the batter data from file 810 is encrypted using the private key generated by the private key generator 820 and the encrypted battery data file is uploaded to a data storage platform 910 in the cloud and stored in a data repository 915.

The digital twin 704 generates data related to battery cycles, energy capacity and power capacity that have a close correlation with historical battery data that is collected and received by the battery data repository 915 from the VPP 160 for the purpose of warranty tracking. The private key generated by the private key generator 820 is stored within the BESS unit controller 110 of the BESS container 120.

The data storage platform 910 includes a key generator 920 that can generate both a public encryption key as well as a private encryption key. When battery data is requested by a user 950 at a remote operation center 955 the encrypted battery files from the data repository 915 are downloaded to the user 950 at remote operation center 955. A public encryption key generated by the key generator 920 at the data storage platform is also sent along with the encrypted files for use by a decryption agent 960. Using the public key, the encrypted data file is decrypted by the decryption agent 960 into a plain text battery data file.

Once decrypted back to plain text, the battery data cannot be encrypted back into the downloaded encrypted form without the originally generated private encryption key. Since the private key remained in BESS unit controller 110, the private key is not available to user 950 at the remote operation center 955. Any attempts to generate the private key would require that the battery data be made available and passed as inputs to the battery model that generated the data along with the unique identifier. Any attempts to generate the same private key will require the same battery data to be provided as inputs to the battery model 760 at the BESS system, for the identifier to match. Tampered data will result in a mismatch and will not generate the same private key for use by the encryption agent 815.

A battery model can be updated by a human expert user 750 using battery parameters validated by the expert as described in the embodiment shown in FIG. 7. The parameter update to reflect the changes due to age and usage of the physical battery. An encrypted data file that is required to be updated and which is stored in the data repository 915 is decrypted by a decryption agent 930 using a public key generated by key generator 920 using the data from the existing battery model. The decrypted or plain text data is coupled to a battery digital twin learning agent 515.

The digital twin learning agent 515 also receives the battery parameters validated by the human expert user 750. The updated battery model is further coupled as an input to a hybrid physics & RNN battery model 760 to generate a new private key for the updated battery model. The simulated battery model data from battery model 760 is coupled to key generator 920 that generates a new private encryption key that is input to encryption agent 945 that encrypts the updated battery data for storage in the data repository 915. This cycle is repeated every time the battery model is updated. This method ensures the private and public key pairs for encrypting the battery data keep changing periodically. This method also ensures that newer data is not passed as older data for the purpose of warranty replacements, apart from enabling detection of data tamper.

It may be advantageous to set forth definitions of certain words and phrases used throughout this patent document. The term "communicate," as well as derivatives thereof, encompasses both direct and indirect communication. The terms "include" and "comprise," as well as derivatives thereof, mean inclusion without limitation. The term "or" is inclusive, meaning and/or. The phrase "associated with," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, have a relationship to or with, or the like. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

The description in the present application should not be read as implying that any particular element, step, or function is an essential or critical element that must be included in the claim scope. The scope of patented subject matter is defined only by the allowed claims. Use of terms such as (but not limited to) "mechanism," "module," "device," "unit," "component," "element," "member," "apparatus," "machine," "system," or "controller" within a claim is understood and intended to refer to structures known to those skilled in the relevant art, as further modified or enhanced by the features of the claims themselves.

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the scope of this disclosure, as defined by the following claims.

**Claims**

1.    A system for detecting the degradation of a storage battery for at least one battery energy storage system, BESS, (120) container, the system comprising:

    a battery management system, BMS, (518, 520) coupled to the storage battery configured to collect battery operational data from the storage battery;
    a battery data repository (915) coupled to the BMS for receiving and storing the battery operational data; and
    a learning agent (515) coupled to the battery data repository that uses the stored battery operational data to estimate a prognostic degradation of the storage battery and train a degradation estimation model, wherein a state of charge, SOC, estimation agent (525) receives and uses the trained degradation estimation model to generate a real-time estimate of the SOC of the storage battery for scheduling charge/discharge cycles for the BESS container.

2.    The system of claim 1, wherein the storage battery of the BESS container is comprised of a plurality of battery cells organized into a plurality of battery modules and the battery modules are further organized into a plurality of battery racks each battery rack of the plurality of battery racks includes a battery rack BMS that collects the operational data of the plurality of battery cells contained in the battery rack, wherein the operational data includes the voltage, current and temperature of all the battery cells contained in the battery rack.

3.    The system of claim 2, wherein each battery rack BMS is coupled to a multi-level BMS configured to receive the operational data from each of the battery racks of the BESS container and estimate an SOC and state of health, SOH, for each battery rack.

4. The system of claim 1, wherein the learning agent is associated with the at least one BESS container and includes: a digital twin comprising a Multiphysics model that simulates the battery organization of the storage battery of the BESS container, wherein the digital twin is trained with time-series operational data stored in the battery data repository from the least one or more BESS containers and wherein the digital twin using a recurrent neural network, RNN, generates the degradation estimation model.

5. The system of claim 2, wherein the at least one BESS container includes:
a BESS unit controller executing the SOC estimation agent, the SOC estimation agent including:

   a first level aggregation of digital twins for each battery module, the battery module digital twins receiving thermal parameters from a battery thermal model associated with each battery cell contained in each battery module that generates an estimate of a battery cell's surface temperature;
   a second level aggregation of digital twins having a digital twin for each battery rack configured to provide an ambient temperature and an estimated battery current scaling factor for the battery cells contained in each battery module; and
   wherein the thermal model uses an RNN battery model to estimate the degradation in energy and power capacity of each individual battery cell.

6. The system of claim 5, wherein each battery module digital twin includes: a battery cell degradation cost aggregation module that receives an estimate of the degradation of the power and energy capacity available from each RNN battery model and outputs an aggregated degradation cost for the battery cells contained in each battery module, and each BESS battery rack digital twin includes:
a battery module degradation cost aggregation module that receives the aggregated degradation for each battery cell contained in the battery module and outputs an aggregated degradation cost for each battery module contained in the battery rack, and
each BESS container includes:
a container degradation cost aggregation module that receives the aggregated degradation for the battery racks of a BESS container and outputs an aggregated degradation cost to a battery energy control system, wherein the battery energy control system considers the battery degradation cost from the container degradation cost aggregation module to minimize the cost associated with the charging / discharging of the BESS storage battery.

7. The system of claim 2, wherein the BMS collects battery operational data from the storage battery including an actual voltage response and actual rise in temperature, the system further including:

   a battery digital twin that is configured to receive operational data from the BESS container including charge/-discharge current and ambient temperature to generate a simulated voltage response and a simulated rise in temperature;
   a mean square error model that receives the actual voltage response and actual rise in temperature from the BMS and the simulated voltage response and simulated rise in temperature from the battery digital twin configured to output a mean square error output;
   a hybrid parameter identification model that receives the mean square error output to generate estimates of changes in battery parameters based on charge/discharge current and ambient temperature input to the hybrid parameter identification model,
   wherein the changes in the battery parameters are uploaded to an expert user that confirms and validates the changes in the battery parameters before downloading the changes in the battery parameters to an RNN battery model associated with the battery digital twin that is trained with past time-series operational data and that is configured to generate as outputs an estimate for simulated voltage response, simulated rise in temperature SOC, SOH, and cycle count during partial cycles of the storage battery.

8. The system of claim 7, wherein the battery operational data is stored as a plain text file in the BESS container, the system further comprising:

   a private key generator coupled to the RNN battery model, the RNN battery model configured to send simulated battery data and a unique identifier to the private key generator that produces a private encryption key that is coupled to an encryption agent, wherein the plain text file is encrypted into an encrypted text file by the encryption agent using the private encryption key;

a data storage platform remotely located from the BESS container having a data repository, the data repository coupled to the encryption agent and arranged to receive and store the encrypted text file;

a key generator located on the data storage platform coupled to the RNN battery model configured to generate a public encryption key using the simulated battery data from the RNN battery model; and

a decryption agent coupled to the data repository and the key generator that upon request of a user receives the encrypted text file and public encryption key and decrypts the encrypted text file to a plain text file.

9. The system of claim 8, wherein using the learning agent the stored encrypted text file in the data repository is configured to be updated using the changed battery parameters from the expert user to the RNN battery model to generate a new private key for the updated battery model, wherein the simulated battery data from the battery model is coupled to the key generator that generates a new private encryption key that is input to an encryption agent located on the data storage platform that uses the new private encryption key to encrypt the changed battery parameters into an encrypted text file for storage in the data repository.

10. A method for detecting the degradation of a storage battery of at least one battery energy storage system, BESS, container, the method comprising:

collecting battery operational data from a battery management system, BMS, coupled to the storage battery;

storing the battery operational data in a data repository;

training a degradation estimation model using the stored battery operational data to estimate a prognostic degradation of the storage battery; and

generating using the trained degradation estimation model a real-time estimate of the state of charge, SOC, of the storage battery for scheduling charge/discharge cycles for the storage battery.

11. The method of claim 10, wherein the storage battery of the BESS container is comprised of a plurality of battery cells organized into a plurality of battery modules and the battery modules are further organized into a plurality of battery racks, the method further comprising:

providing a battery rack BMS that collects the operational data of the plurality of battery cells contained in the battery rack; and

the step of collecting battery operational data collects the voltage, current and temperature of all the battery cells contained in the battery rack.

12. The method of claim 11, wherein the BMS collects battery operational data from the storage battery including an actual voltage response and actual rise in temperature, the method further including:

receiving operational data from BESS container including charge/discharge current and ambient temperature by a battery digital twin;

generating by the battery digital twin a simulated voltage response and a simulated rise in temperature using the operational data;

generating a means square error output using the actual voltage response and actual rise in temperature from the BMS and the simulated voltage response and simulated temperature from the digital twin;

generating estimates of changes in battery parameters based on charge/discharge current and ambient temperature using the mean square error output; and

presenting the changes in the battery parameters to an expert user for review and validation of the changed battery parameters.

13. The method of claim 12, wherein the method further includes:

downloading the changes in the battery parameters to an RNN battery model associated with the battery digital twin that is trained with past time-series operational data; and

generating by the digital twin an estimate for simulated voltage response, simulated rise in temperature SOC, SOH, and cycle count during partial cycles of the storage battery.

14. The method of claim 13, wherein the battery operational data is stored as a plain text file in the BESS container, the method further comprising:

providing a private key generator coupled to the RNN battery model, the RNN battery model configured to send simulated battery data and a unique identifier to the private key generator to produce a private encryption key, wherein the private encryption key is used by an encryption agent to encrypt the plain text file;

storing the encrypted text file in a data repository of data storage platform remotely located from the BESS container;

providing a key generator located on the data storage platform coupled to the RNN battery model configured to generate a public encryption key using the simulated battery data from the RNN battery model; and

sending upon a request of a user the encrypted text file and public encryption key to a decryption agent that decrypts the encrypted text file to a plain text file.

15. The method of claim 14, wherein using the learning agent the stored encrypted text file in the data repository is updated using the changed battery parameters from the expert user to the RNN battery model that generates a new private key for the updated battery model, wherein the simulated battery data from the battery model is coupled to the key generator that generates a new private encryption key that is input to an encryption agent located on the data storage platform that uses the new private encryption key to encrypt the changed battery parameters into an encrypted text file for storage in the data repository.

**Patentansprüche**

1. System zum Detektieren der Verschlechterung einer Speicherbatterie für mindestens einen Batterieenergiespeichersystem, BESS, (120)-Container, das System umfassend:

ein mit der Speicherbatterie gekoppeltes Batteriemanagementsystem, BMS, (518, 520), das dazu konfiguriert ist, Batteriebetriebsdaten von der Speicherbatterie zu erfassen;

ein mit dem BMS gekoppeltes Batteriedatenrepositorium zum Empfangen und Speichern der Batteriebetriebsdaten (915); und

einen mit dem Batteriedatenrepositorium gekoppelten lernenden Agenten (515), der die gespeicherten Batteriebetriebsdaten verwendet, um eine prognostische Verschlechterung der Speicherbatterie zu schätzen und ein Verschlechterungsschätzmodell zu trainieren,

wobei ein Ladezustand, SOC, -Schätzagent (525) das trainierte Verschlechterungsschätzmodell empfängt und verwendet, um eine Echtzeitschätzung des SOC der Speicherbatterie zum Planen von Lade-/Entladezyklen für den BESS-Container zu erzeugen.

2. System nach Anspruch 1, wobei die Speicherbatterie des BESS-Containers aus einer Vielzahl von Batteriezellen umfasst ist, die in einer Vielzahl von Batteriemodulen organisiert sind, und die Batteriemodule ferner in einer Vielzahl von Batteriegestellen organisiert sind, wobei jedes Batteriegestell der Vielzahl von Batteriegestellen ein Batteriegestell-BMS beinhaltet, das die Betriebsdaten der Vielzahl von in dem Batteriegestell enthaltenen Batteriezellen erfasst, wobei die Betriebsdaten die Spannung, den Strom und die Temperatur aller der in dem Batteriegestell enthaltenen Batteriezellen beinhalten.

3. System nach Anspruch 2, wobei jedes Batteriegestell-BMS mit einem Mehrebenen-BMS gekoppelt ist, das dazu konfiguriert ist, die Betriebsdaten von jedem der Batteriegestelle des BESS-Containers zu empfangen und einen SOC und einen Gesundheitszustand, SOH, für jedes Batteriegestell zu schätzen.

4. System nach Anspruch 1, wobei der lernende Agent dem mindestens einen BESS-Container zugeordnet ist und Folgendes beinhaltet:
einen digitalen Zwilling, umfassend ein Multiphysik-Modell, das die Batterieorganisation der Speicherbatterie des BESS-Containers simuliert, wobei der digitale Zwilling mit in dem Batteriedatenrepositorium gespeicherten Zeitreihenbetriebsdaten von dem mindestens einen oder den mehreren BESS-Containern trainiert wird und wobei der digitale Zwilling unter Verwendung eines rekurrenten neuronalen Netzes, RNN, das Verschlechterungsschätzmodell erzeugt.

5. System nach Anspruch 2, wobei der mindestens eine BESS-Container Folgendes beinhaltet:
eine BESS-Einheitssteuerung, die den SOC-Schätzagenten ausführt, wobei der SOC-Schätzagent Folgendes beinhaltet:

eine Erstebenen-Aggregation von digitalen Zwillingen für jedes Batteriemodul, wobei die digitalen Batteriemodulzwillinge thermische Parameter von einem thermischen Batteriemodell empfangen, das jeder Batteriezelle zugeordnet ist, die in jedem Batteriemodul enthalten ist, das eine Schätzung einer Oberflächentemperatur der Batteriezelle erzeugt;

eine Zweitebenen-Aggregation von digitalen Zwillingen, die einen digitalen Zwilling für jedes Batteriegestell aufweist, der dazu konfiguriert ist, eine Umgebungstemperatur und einen geschätzten Batteriestromskalierungsfaktor für die in jedem Batteriemodul enthaltenen Batteriezellen bereitzustellen; und

wobei das thermische Modul ein RNN-Batteriemodell verwendet, um die Verschlechterung der Energie- und Leistungskapazität jeder einzelnen Batteriezelle zu schätzen.

6. System nach Anspruch 5, wobei jeder digitale Batteriemodulzwilling Folgendes beinhaltet: ein Batteriezellenverschlechterungskosten-Aggregationsmodul, das von jedem RNN-Batteriemodell eine Schätzung der Verschlechterung der verfügbaren Leistungs- und Energiekapazität empfängt und aggregierte Verschlechterungskosten für die in jedem Batteriemodul enthaltenen Batteriezellen ausgibt, und jeder digitale BESS-Batteriegestellzwilling Folgendes beinhaltet:

ein Batteriemodulverschlechterungskosten-Aggregationsmodul, das die aggregierte Verschlechterung für jede in dem Batteriemodul enthaltene Batteriezelle empfängt und aggregierte Verschlechterungskosten für jedes in dem Batteriegestell enthaltene Batteriemodul ausgibt, und

jeder BESS-Container Folgendes beinhaltet:

ein Containerverschlechterungskosten-Aggregationsmodul, das die aggregierte Verschlechterung für die Batteriegestelle eines BESS-Containers empfängt und aggregierte Verschlechterungskosten an ein Batterieenergiesteuersystem ausgibt, wobei das Batterieenergiesteuersystem die Batterieverschlechterungskosten von dem Containerverschlechterungskosten-Aggregationsmodul berücksichtigt, um die dem Laden/Entladen der BESS-Speicherbatterie zugeordneten Kosten zu minimieren.

7. System nach Anspruch 2, wobei das BMS Batteriebetriebsdaten von der Speicherbatterie erfasst, die eine tatsächliche Spannungsantwort und einen tatsächlichen Temperaturanstieg beinhalten, das System ferner beinhaltend:

einen digitalen Batteriezwilling, der dazu konfiguriert ist, Betriebsdaten von dem BESS-Container zu empfangen, die einen Lade-/Entladestrom und eine Umgebungstemperatur beinhalten, um eine simulierte Spannungsantwort und einen simulierten Temperaturanstieg zu erzeugen;

ein Modell des mittleren quadratischen Fehlers, das die tatsächliche Spannungsantwort und den tatsächlichen Temperaturanstieg von dem BMS und die simulierte Spannungsantwort und den simulierten Temperaturanstieg von dem digitalen Batteriezwilling empfängt und dazu konfiguriert ist, eine Ausgabe des mittleren quadratischen Fehlers auszugeben;

ein Hybridparameteridentifikationsmodell, das die Ausgabe des mittleren quadratischen Fehlers empfängt, um Schätzungen von Änderungen der Batterieparameter auf Basis einer Lade-/Entladestrom- und Umgebungstemperatureingabe in das Hybridparameteridentifikationsmodell zu erzeugen,

wobei die Änderungen der Batterieparameter an einen fachkundigen Benutzer hochgeladen werden, der die Änderungen der Batterieparameter bestätigt und validiert, bevor die Änderungen der Batterieparameter in ein dem digitalen Batteriezwilling zugeordnetes RNN-Batteriemodell heruntergeladen werden, das mit vergangenen Zeitreihenbetriebsdaten trainiert wird und dazu konfiguriert ist, eine Schätzung für eine simulierte Spannungsantwort, einen simulierten Temperaturanstieg, einen SOC, einen SOH und eine Zykluszählung während Teilzyklen der Speicherbatterie als Ausgaben zu erzeugen.

8. System nach Anspruch 7, wobei die Batteriebetriebsdaten als Nur-Text-Datei in dem BESS-Container gespeichert sind, das System ferner umfassend:

einen Privatschlüsselerzeuger, der mit dem RNN-Batteriemodell gekoppelt ist, wobei das RNN-Batteriemodell dazu konfiguriert ist, simulierte Batteriedaten und eine eindeutige Kennung an den Privatschlüsselerzeuger zu senden, der einen Privatverschlüsselungsschlüssel hervorbringt, der mit einem Verschlüsselungsagenten gekoppelt ist, wobei die Nur-Text-Datei von dem Verschlüsselungsagenten unter Verwendung des Privatverschlüsselungsschlüssels in eine verschlüsselte Textdatei verschlüsselt wird;

eine entfernt von dem BESS-Container befindliche Datenspeicherplattform, die ein Datenrepositorium aufweist, wobei das Datenrepositorium mit dem Verschlüsselungsagenten gekoppelt und dazu angeordnet ist, die verschlüsselte Textdatei zu empfangen und zu speichern;

einen auf der Datenspeicherplattform befindlichen Schlüsselerzeuger, der mit dem RNN-Batteriemodell gekoppelt und dazu konfiguriert ist, unter Verwendung der simulierten Batteriedaten von dem RNN-Batteriemodell einen öffentlichen Verschlüsselungsschlüssel zu erzeugen; und

einen mit dem Datenrepositorium und dem Schlüsselerzeuger gekoppelten Entschlüsselungsagenten, der auf Anfrage eines Benutzers die verschlüsselte Textdatei und den öffentlichen Verschlüsselungsschlüssel empfängt und die verschlüsselte Textdatei in eine Nur-Text-Datei entschlüsselt.

9. System nach Anspruch 8, wobei unter Verwendung des lernenden Agenten die in dem Datenrepositorium gespeicherte verschlüsselte Textdatei dazu konfiguriert ist, unter Verwendung der geänderten Batterieparameter von dem fachkundigen Benutzer zu dem RNN-Batteriemodell aktualisiert zu werden, um einen neuen privaten Schlüssel für das aktualisierte Batteriemodell zu erzeugen, wobei die simulierten Batteriedaten von dem Batteriemodell mit dem Schlüsselerzeuger gekoppelt sind, der einen neuen privaten Verschlüsselungsschlüssel erzeugt, der in einen auf der Datenspeicherplattform befindlichen Verschlüsselungsagenten eingegeben wird, der den neuen privaten Verschlüsselungsschlüssel verwendet, um die geänderten Batterieparameter in eine verschlüsselte Textdatei zur Speicherung in dem Datenrepositorium zu verschlüsseln.

10. Verfahren zum Detektieren der Verschlechterung einer Speicherbatterie von mindestens einem Batterieenergiespeichersystem, BESS, -Container, das Verfahren umfassend:

Erfassen von Batteriebetriebsdaten von einem mit der Speicherbatterie gekoppelten Batteriemanagementsystem, BMS;
Speichern der Batteriebetriebsdaten in einem Datenrepositorium;
Trainieren eines Verschlechterungsschätzmodells unter Verwendung der gespeicherten Batteriebetriebsdaten, um eine prognostische Verschlechterung der Speicherbatterie zu schätzen; und
Erzeugen, unter Verwendung des trainierten Verschlechterungsschätzmodells, einer Echtzeitschätzung des Ladezustands, SOC, der Speicherbatterie zum Planen von Lade-/Entladezyklen für die Speicherbatterie.

11. Verfahren nach Anspruch 10, wobei die Speicherbatterie des BESS-Containers aus einer Vielzahl von Batteriezellen umfasst ist, die in einer Vielzahl von Batteriemodulen organisiert sind, und die Batteriemodule ferner in einer Vielzahl von Batteriegestellen organisiert sind, das Verfahren ferner umfassend:

Bereitstellen eines Batteriegestell-BMS, das die Betriebsdaten der Vielzahl von in dem Batteriegestell enthaltenen Batteriezellen erfasst; und
der Schritt des Erfassens von Batteriebetriebsdaten die Spannung, den Strom und die Temperatur aller der in dem Batteriegestell enthaltenen Batteriezellen erfasst.

12. Verfahren nach Anspruch 11, wobei das BMS Batteriebetriebsdaten von der Speicherbatterie erfasst, die eine tatsächliche Spannungsantwort und einen tatsächlichen Temperaturanstieg beinhalten, das Verfahren ferner beinhaltend:

Empfangen von Betriebsdaten von einem BESS-Container, die einen Lade-/Entladestrom und eine Umgebungstemperatur beinhalten, durch einen digitalen Batteriezwilling;
Erzeugen, durch den digitalen Batteriezwilling, einer simulierten Spannungsantwort und eines simulierten Temperaturanstiegs unter Verwendung der Betriebsdaten;
Erzeugen einer Ausgabe eines mittleren quadratischen Fehlers unter Verwendung der tatsächlichen Spannungsantwort und des tatsächlichen Temperaturanstiegs von dem BMS und der simulierten Spannungsantwort und der simulierten Temperatur von dem digitalen Zwilling;
Erzeugen von Schätzungen von Änderungen der Batterieparameter auf Basis eines Lade-/Entladestroms und einer Umgebungstemperatur unter Verwendung der Ausgabe des mittleren quadratischen Fehlers; und
Darstellen der Änderungen der Batterieparameter an einen fachkundigen Benutzer zur Überprüfung und Validierung der geänderten Batterieparameter.

13. Verfahren nach Anspruch 12, wobei das Verfahren ferner Folgendes beinhaltet:

Herunterladen der Änderungen der Batterieparameter in ein dem digitalen Batteriezwilling zugeordnetes RNN-Batteriemodell, das mit vergangenen Zeitreihenbetriebsdaten trainiert wird; und
Erzeugen, durch den digitalen Zwilling, einer Schätzung für eine simulierte Spannungsantwort, einen simulierten Temperaturanstieg, einen SOC, einen SOH und eine Zykluszählung während Teilzyklen der Speicherbatterie.

14. Verfahren nach Anspruch 13, wobei die Batteriebetriebsdaten als Nur-Text-Datei in dem BESS-Container gespeichert sind, das Verfahren ferner umfassend:

Bereitstellen eines Privatschlüsselerzeugers, der mit dem RNN-Batteriemodell gekoppelt ist, wobei das RNN-Batteriemodell dazu konfiguriert ist, simulierte Batteriedaten und eine eindeutige Kennung an den Privatschlüsselerzeuger zu senden, um einen Privatverschlüsselungsschlüssel hervorzubringen, wobei der Privatverschlüsselungsschlüssels von einem Verschlüsselungsagenten verwendet wird, um die Nur-Text-Datei zu verschlüsseln;

Speichern der verschlüsselten Textdatei in einem Datenrepositorium einer sich entfernt von dem BESS-Container befindlichen Datenspeicherplattform;

Bereitstellen eines auf der Datenspeicherplattform befindlichen Schlüsselerzeugers, der mit dem RNN-Batteriemodell gekoppelt und dazu konfiguriert ist, unter Verwendung der simulierten Batteriedaten aus dem RNN-Batteriemodell einen öffentlichen Verschlüsselungsschlüssel zu erzeugen; und

Senden, auf Anfrage eines Benutzers, der verschlüsselten Textdatei und des öffentlichen Verschlüsselungsschlüssels an einen Entschlüsselungsagenten, der die verschlüsselte Textdatei in eine Nur-Text-Datei entschlüsselt.

15. Verfahren nach Anspruch 14, wobei unter Verwendung des lernenden Agenten die in dem Datenrepositorium gespeicherte verschlüsselte Textdatei unter Verwendung der geänderten Batterieparameter von dem fachkundigen Benutzer zu dem RNN-Batteriemodell aktualisiert wird, das einen neuen privaten Schlüssel für das aktualisierte Batteriemodell erzeugt, wobei die simulierten Batteriedaten aus dem Batteriemodell mit dem Schlüsselerzeuger gekoppelt sind, der einen neuen privaten Verschlüsselungsschlüssel erzeugt, der in einen auf der Datenspeicherplattform befindlichen Verschlüsselungsagenten eingegeben wird, der den neuen privaten Verschlüsselungsschlüssel verwendet, um die geänderten Batterieparameter in eine verschlüsselte Textdatei zur Speicherung in dem Datenrepositorium zu verschlüsseln.

**Revendications**

1. Système de détection de la dégradation d'une batterie de stockage pour au moins un conteneur de système de stockage d'énergie par batterie, BESS, (120), le système comprenant :

un système de gestion de batterie, BMS, (518, 520) couplé à la batterie de stockage configuré pour collecter des données opérationnelles de batterie provenant de la batterie de stockage ;
un dépôt de données de batterie (915) couplé au BMS pour recevoir et stocker les données opérationnelles de batterie ; et
un agent d'apprentissage (515) couplé au dépôt de données de batterie qui utilise les données opérationnelles de batterie stockées pour estimer une dégradation pronostique de la batterie de stockage et entraîner un modèle d'estimation de dégradation,
dans lequel un agent d'estimation de l'état de charge, SOC, (525) reçoit et utilise le modèle d'estimation de dégradation entraîné pour générer une estimation en temps réel du SOC de la batterie de stockage pour planifier les cycles de charge/décharge du conteneur BESS.

2. Système de la revendication 1, dans lequel la batterie de stockage du conteneur BESS est constituée d'une pluralité de cellules de batterie organisées en une pluralité de modules de batterie et les modules de batterie sont en outre organisés en une pluralité de racks de batterie, chaque rack de batterie de la pluralité de racks de batterie incluant un BMS de rack de batterie qui collecte les données opérationnelles de la pluralité de cellules de batterie contenues dans le rack de batterie, dans lequel les données opérationnelles incluent la tension, le courant et la température de toutes les cellules de batterie contenues dans le rack de batterie.

3. Système de la revendication 2, dans lequel chaque BMS de rack de batterie est couplé à un BMS multiniveau configuré pour recevoir les données opérationnelles provenant de chacun des racks de batterie du conteneur BESS et estimer un SOC et un état de santé, SOH, pour chaque rack de batterie.

4. Système de la revendication 1, dans lequel l'agent d'apprentissage est associé audit au moins un conteneur BESS et inclut :

un jumeau numérique comprenant un modèle multiphysique qui simule l'organisation de la batterie de stockage du conteneur BESS, dans lequel le jumeau numérique est entraîné avec des données de fonctionnement sous forme de séries temporelles stockées dans le dépôt de données de batterie provenant dudit au moins un ou plusieurs conteneurs BESS, et dans lequel le jumeau numérique, utilisant un réseau neuronal récurrent, RNN, génère le modèle d'estimation de dégradation.

5. Système de la revendication 2, dans lequel ledit au moins un conteneur BESS inclut :
un contrôleur d'unité BESS exécutant l'agent d'estimation de SOC, l'agent d'estimation de SOC incluant :

un premier niveau d'agrégation de jumeaux numériques pour chaque module de batterie, les jumeaux numériques de module de batterie recevant des paramètres thermiques provenant d'un modèle thermique de batterie associé à chaque cellule de batterie contenue dans chaque module de batterie qui génère une estimation de la température de surface d'une cellule de batterie ;
un deuxième niveau d'agrégation de jumeaux numériques comportant un jumeau numérique pour chaque rack de batterie configuré pour fournir une température ambiante et un facteur d'échelle de courant de batterie estimé pour les cellules de batterie contenues dans chaque module de batterie ; et
dans lequel le modèle thermique utilise un modèle de batterie RNN pour estimer la dégradation de la capacité énergétique et de puissance de chaque cellule de batterie individuelle.

6. Système de la revendication 5, dans lequel chaque jumeau numérique de module de batterie inclut : un module d'agrégation des coûts de dégradation de cellule de batterie qui reçoit une estimation de la dégradation de la capacité de puissance et d'énergie disponible provenant de chaque modèle de batterie RNN et délivre un coût de dégradation agrégé pour les cellules de batterie contenues dans chaque module de batterie, et chaque jumeau numérique de rack de batterie BESS inclut :
un module d'agrégation de coût de dégradation de module de batterie qui reçoit la dégradation agrégée pour chaque cellule de batterie contenue dans le module de batterie et délivre un coût de dégradation agrégé pour chaque module de batterie contenu dans le rack de batterie, et
chaque conteneur BESS inclut :
un module d'agrégation de coût de dégradation de conteneur qui reçoit la dégradation agrégée pour les racks de batterie d'un conteneur BESS et délivre un coût de dégradation agrégé à un système de contrôle d'énergie de batterie, dans lequel le système de contrôle d'énergie de batterie considère le coût de dégradation de batterie provenant du module d'agrégation de coût de dégradation de conteneur pour minimiser le coût associé à la charge/décharge de la batterie de stockage du BESS.

7. Système de la revendication 2, dans lequel le BMS collecte des données opérationnelles de batterie provenant de la batterie de stockage incluant une réponse de tension réelle et une élévation réelle de température, le système incluant en outre :

un jumeau numérique de batterie configuré pour recevoir des données opérationnelles provenant du conteneur BESS incluant le courant de charge/décharge et la température ambiante afin de générer une réponse de tension simulée et une élévation simulée de température ;
un modèle d'erreur quadratique moyenne qui reçoit la réponse de tension réelle et l'élévation réelle de température provenant du BMS et la réponse de tension simulée et l'élévation simulée de température provenant du jumeau numérique de batterie configuré pour délivrer une sortie d'erreur quadratique moyenne ;
un modèle d'identification de paramètres hybride qui reçoit la sortie d'erreur quadratique moyenne pour générer des estimations de changements de paramètres de batterie basées sur le courant de charge/décharge et la température ambiante transmis au modèle d'identification de paramètres hybride,
dans lequel les changements des paramètres de batterie sont téléchargés vers un utilisateur expert qui confirme et valide les changements des paramètres de batterie avant de télécharger les changements des paramètres de batterie dans un modèle de batterie RNN associé au jumeau numérique de batterie qui est entraîné avec des données historiques de fonctionnement sous forme de séries temporelles et qui est configuré pour générer en sortie une estimation de réponse de tension simulée, d'élévation simulée de température, de SOC, de SOH, et de nombre de cycles pendant les cycles partiels de la batterie de stockage.

8. Système de la revendication 7, dans lequel les données opérationnelles de batterie sont stockées sous forme de fichier texte en clair dans le conteneur BESS, le système comprenant en outre :

un générateur de clé privée couplé au modèle de batterie RNN, le modèle de batterie RNN étant configuré pour envoyer des données de batterie simulées et un identifiant unique au générateur de clé privée qui produit une clé de chiffrement privée qui est couplée à un agent de chiffrement, dans lequel le fichier texte en clair est chiffré en un fichier texte chiffré par l'agent de chiffrement utilisant la clé de chiffrement privée ;
une plateforme de stockage de données située à distance provenant du conteneur BESS comportant un dépôt de

**EP 4 549 967 B1**

données, le dépôt de données étant couplé à l'agent de chiffrement et agencé pour recevoir et stocker le fichier texte chiffré ;

un générateur de clé situé sur la plateforme de stockage de données couplé au modèle de batterie RNN configuré pour générer une clé de chiffrement publique utilisant les données de batterie simulées provenant du modèle de batterie RNN ; et

un agent de déchiffrement couplé au dépôt de données et au générateur de clé qui, sur demande d'un utilisateur, reçoit le fichier texte chiffré et la clé de chiffrement publique et déchiffre le fichier texte chiffré en un fichier texte en clair.

9. Système de la revendication 8, dans lequel, en utilisant l'agent d'apprentissage, le fichier texte chiffré stocké dans le dépôt de données est configuré pour être mis à jour en utilisant les paramètres de batterie modifiés provenant de l'utilisateur expert vers le modèle de batterie RNN pour générer une nouvelle clé privée pour le modèle de batterie mis à jour, dans lequel les données de batterie simulées provenant du modèle de batterie sont couplées au générateur de clé qui génère une nouvelle clé de chiffrement privée qui est fournie à un agent de chiffrement situé sur la plateforme de stockage de données qui utilise la nouvelle clé de chiffrement privée pour chiffrer les paramètres de batterie modifiés dans un fichier texte chiffré pour stockage dans le dépôt de données.

10. Procédé de détection de la dégradation d'une batterie de stockage d'au moins un conteneur de système de stockage d'énergie par batterie, BESS, le procédé comprenant :

la collecte des données opérationnelles de batterie à partir d'un système de gestion de batterie, BMS, couplé à la batterie de stockage ;
le stockage des données opérationnelles de batterie dans un dépôt de données ;
l'entraînement d'un modèle d'estimation de dégradation en utilisant les données opérationnelles de batterie stockées pour estimer une dégradation pronostique de la batterie de stockage ; et
la génération, à l'aide du modèle d'estimation de dégradation entraîné, d'une estimation en temps réel de l'état de charge, SOC, de la batterie de stockage pour planifier les cycles de charge/décharge de la batterie de stockage.

11. Procédé de la revendication 10, dans lequel la batterie de stockage du conteneur BESS est constituée d'une pluralité de cellules de batterie organisées en une pluralité de modules de batterie et les modules de batterie sont en outre organisés en une pluralité de racks de batterie, le procédé comprenant en outre :

la mise à disposition d'un BMS de rack de batterie qui collecte les données opérationnelles de la pluralité de cellules de batterie contenues dans le rack de batterie ; et
l'étape de collecte des données opérationnelles de batterie collecte la tension, le courant et la température de toutes les cellules de batterie contenues dans le rack de batterie.

12. Procédé de la revendication 11, dans lequel le BMS collecte des données opérationnelles de batterie provenant de la batterie de stockage incluant une réponse de tension réelle et une élévation réelle de température, le procédé incluant en outre :

la réception des données opérationnelles provenant du conteneur BESS incluant le courant de charge/décharge et la température ambiante par un jumeau numérique de batterie ;
la génération, par le jumeau numérique de batterie, d'une réponse de tension simulée et une élévation simulée de température à l'aide des données opérationnelles ;
la génération d'une sortie d'erreur quadratique moyenne en utilisant la réponse de tension réelle et l'élévation réelle de température provenant du BMS et la réponse de tension simulée et la température simulée provenant du jumeau numérique ;
la génération des estimations de changements des paramètres de batterie basées sur le courant de charge/décharge et la température ambiante en utilisant la sortie d'erreur quadratique moyenne ; et
la présentation des changements des paramètres de batterie à un utilisateur expert pour examen et validation des paramètres de batterie modifiés.

13. Procédé de la revendication 12, dans lequel le procédé inclut en outre :

le téléchargement des changements des paramètres de batterie dans un modèle de batterie RNN associé au jumeau numérique de batterie qui est entraîné avec des données historiques de fonctionnement sous forme de séries temporelles ; et

la génération, par le jumeau numérique, d'une estimation de réponse de tension simulée, d'élévation simulée de température, de SOC, de SOH, et de nombre de cycles pendant les cycles partiels de la batterie de stockage.

**14.** Procédé de la revendication 13, dans lequel les données opérationnelles de batterie sont stockées sous forme de fichier texte en clair dans le conteneur BESS, le procédé comprenant en outre :

la mise à disposition d'un générateur de clé privée couplé au modèle de batterie RNN, le modèle de batterie RNN étant configuré pour envoyer des données de batterie simulées et un identifiant unique au générateur de clé privée pour produire une clé de chiffrement privée, dans laquelle la clé de chiffrement privée est utilisée par un agent de chiffrement pour chiffrer le fichier texte en clair ;

le stockage du fichier texte chiffré dans un dépôt de données d'une plateforme de stockage de données située à distance du conteneur BESS ;

la mise à disposition d'un générateur de clé situé sur la plateforme de stockage de données couplé au modèle de batterie RNN configuré pour générer une clé de chiffrement publique utilisant les données de batterie simulées provenant du modèle de batterie RNN ; et

l'envoi, sur demande d'un utilisateur, du fichier texte chiffré et de la clé de chiffrement publique à un agent de déchiffrement qui déchiffre le fichier texte chiffré en un fichier texte en clair.

**15.** Procédé de la revendication 14, dans lequel, en utilisant l'agent d'apprentissage, le fichier texte chiffré stocké dans le dépôt de données est mis à jour en utilisant les paramètres de batterie modifiés provenant de l'utilisateur expert vers le modèle de batterie RNN qui génère une nouvelle clé privée pour le modèle de batterie mis à jour, dans lequel les données de batterie simulées provenant du modèle de batterie sont couplées au générateur de clé qui génère une nouvelle clé de chiffrement privée qui est transmise à un agent de chiffrement situé sur la plateforme de stockage de données qui utilise la nouvelle clé de chiffrement privée pour chiffrer les paramètres de batterie modifiés dans un fichier texte chiffré pour stockage dans le dépôt de données.

FIG. 1

FIG. 2

FIG. 3

EP 4 549 967 B1

FIG. 4

EP 4 549 967 B1

FIG. 5

EP 4 549 967 B1

FIG. 6

EP 4 549 967 B1

700

**DIGITAL TWIN 704**

EXPERT USER 750

HYBRID BATTERY PARAMETER IDENTIFICATION MODEL 730

CHARGE/DISCHARGE CURRENT
AMBIENT TEMPERATURE

PARAMETERS

PARAMETERS VALIDATED BY EXPERT USER

HYBRID PHYSICS & RNN BATTERY MODEL 760

SIMULATED VOLTAGE RESPONSE
SIMULATED RISE IN TEMP
SOC
SOH
BATTERY ENERGY CAP
BATTERY POWER CAP
BATTERY CYCLE COUNT

MEAN SQUARED ERROR BETWEEN SIMULATED AND ACTUAL VOLTAGE & TEMPERATURE 720

CELL LEVEL ANOMALY DETECTION MODEL 770

**PHYSICAL SYSTEM 701**

BATTERY RACK 710

BATTERY MANAGEMENT SYSTEM 715

BESS UNIT CONTROLLER 110

AMBIENT TEMPERATURE

ACTUAL VOLTAGE RESPONSE
ACTUAL RISE IN TEMP
SOC
SOH
BATTERY ENERGY CAP
BATTERY POWER CAP
BATTERY CYCLE COUNT

FIG. 7

FIG. 8

EP 4 549 967 B1

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 115291113 A